# EUROPEAN PATENT APPLICATION

(11) **EP 4 685 854 A1**
(43) Date of publication of application: **28.01.2026**
(21) Application number: 23928862.4
(22) Date of filing: 12.07.2023
(51) Int. Cl.: H01L 33/44, H01L 33/38, H01L 33/20, H01L 27/15

(54) **LIGHT-EMITTING ELEMENT AND DISPLAY DEVICE COMPRISING SAME**

(30) Priority: 20.03.2023 KR 20230035833
(71) Applicant: Samsung Display Co., Ltd., Yongin-si, Gyeonggi-do 17113 (KR)
(72) Inventor: YOO, Chul Jong, Yongin-Si Gyeonggi-do 17113 (KR); KIM, Dae Hyun, Yongin-Si Gyeonggi-do 17113 (KR); KIM, In Hyuk, Yongin-Si Gyeonggi-do 17113 (KR); SEO, Dong Kyun, Yongin-Si Gyeonggi-do 17113 (KR); SIM, Young Chul, Yongin-Si Gyeonggi-do 17113 (KR); JIN, Tae Ha, Yongin-Si Gyeonggi-do 17113 (KR); CHOI, Hyeong Su, Yongin-Si Gyeonggi-do 17113 (KR)
(74) Representative: Marks & Clerk LLP
(86) International application number: PCT/KR2023/009936
(87) International publication number: WO 2024/195938

(57) **Abstract**

A light-emitting element according to an embodiment comprises: a first semiconductor layer, an active layer, and a second semiconductor layer, which are sequentially arranged in one direction; a first insulating film surrounding the outer peripheral surfaces of the first semiconductor layer, the active layer, and the second semiconductor layer and containing an M1ₓO_{y} type oxide; a second insulating film surrounding the first insulating film and containing an M2₂ₓO_{(2y-1)} type oxide; a third insulating film surrounding the second insulating film and containing an M3ₓO_{y} type oxide; and a fourth insulating film surrounding the third insulating film, wherein M1, M2, and M3 may each be a metal material, and x and y may each be a natural number.

## Description

### [Technical Field]

Embodiments of the present disclosure relate to a light-emitting element and a display device comprising same.

### [Background Art]

Display devices are becoming increasingly important with the development of multimedia. Accordingly, various display devices such as liquid crystal display devices and organic light emitting display devices are being developed.

### [Detailed Description of the Invention]

### [Problem to be Solved]

The problem to be solved by the present disclosure is to provide a light-emitting element with improved reliability and a display device comprising the light-emitting element.

The tasks of the present invention are not limited to the tasks mentioned above, and other technical tasks not mentioned will be clearly understood by those skilled in the art from the description below.

### [Technical Solution]

A light-emitting element according to an embodiment may include: a first semiconductor layer, an active layer, and a second semiconductor layer, which are sequentially arranged in one direction; a first insulating film surrounding outer peripheral surfaces of the first semiconductor layer, the active layer and the second semiconductor layer and including an M1ₓO_{y} type oxide; a second insulating film surrounding the first insulating film and including an M2₂ₓO_{(2y-1)} type oxide; a third insulating film surrounding the second insulating film and including an M3ₓO_{y} type oxide; and a fourth insulating film surrounding the third insulating film. Each of M1, M2 and M3 may be a metal material, and *x* and y may each be natural number.

The sum of thicknesses of the first insulating film, the second insulating film, and the third insulating film may be 10 nm or less.

The fourth insulating film may have a thickness greater than the sum of the thicknesses of the first insulating film, the second insulating film, and the third insulating film.

The thickness of the first insulating film may be greater than the thickness of the second insulating film.

The thickness of the third insulating film may be equal to or greater than the thickness of the second insulating film.

The first insulating film may include an M1O₂ type oxide, the second insulating film may include an M2₂O₃ type oxide, and the third insulating film may include an M3O₂ type oxide.

The first insulating film may include at least one of SiO₂, ZrO₂, HfO₂, GeO₂, TiO₂ and TeO₂, and the second insulating film may include at least one of Al₂O₃, Y₂O₃, La₂O₃, Ce₂O₃, Lu₂O₃, Sc₂O₃ and Yb₂O₃.

The third insulating film may include at least one of SiO₂, ZrO₂, HfO₂, GeO₂, TiO₂, and TeO₂.

The first insulating film may include ZrO₂, the second insulating film may include Al₂O₃, and the third insulating film may include ZrO₂.

The light-emitting element may further include a fifth insulating film surrounding the fourth insulating film and having a thickness greater than the thickness of the fourth insulating film.

The fourth insulating film may be an inorganic film including an oxide, and the fifth insulating film may be an inorganic film including an oxide different from a material of the fourth insulating film.

A light-emitting element according to an embodiment may include: a first semiconductor layer, an active layer, and a second semiconductor layer, which are sequentially arranged in one direction; a first insulating film surrounding outer peripheral surfaces of the first semiconductor layer, the active layer and the second semiconductor layer and including an M1ₓO_{y} type oxide; a second insulating film surrounding the first insulating film and including an M2₂ₓO_{(2y-1)} type oxide; and a third insulating film surrounding the second insulating film and including an M3ₓO_{y} type oxide. Each of M1, M2 and M3 may be a metal material, *x* and y may each be a natural number, a thickness of the first insulating film may be greater than a thickness of the second insulating film, and a thickness of the third insulating film may be equal to or greater than the thickness of the second insulating film.

The sum of the thicknesses of the first insulating film, the second insulating film, and the third insulating film may be 10 nm or less.

The first insulating film may include an M1O₂ type oxide, the second insulating film may include an M2₂O₃ type oxide, and the third insulating film may include an M3O₂ type oxide.

The first insulating film may include at least one of SiO₂, ZrO₂, HfO₂, GeO₂, TiO₂ and TeO₂, and the second insulating film may include at least one of Al₂O₃, Y₂O₃, La₂O₃, Ce₂O₃, Lu₂O₃, Sc₂O₃ and Yb₂O₃.

The third insulating film may include at least one of SiO₂, ZrO₂, HfO₂, GeO₂, TiO₂, and TeO₂.

The first insulating film may include ZrO₂, the second insulating film may include Al₂O₃, and the third insulating film may include ZrO₂.

The light-emitting element may further include a fourth insulating film surrounding the third insulating film and having a thickness greater than the sum of the thicknesses of the first insulating film, the second insulating film and the third insulating film.

The light-emitting element may further include a fifth insulating film surrounding the fourth insulating film and having a thickness greater than the thickness of the fourth insulating film.

A display device according to an embodiment may include a pixel which includes a first electrode and a second electrode spaced apart from each other and a light-emitting element electrically connected between the first electrode and the second electrode. The light-emitting element may include: a first semiconductor layer, an active layer, and a second semiconductor layer, which are sequentially arranged in one direction; a first insulating film surrounding outer peripheral surfaces of the first semiconductor layer, the active layer and the second semiconductor layer and including an M1ₓO_{y} type oxide; a second insulating film surrounding the first insulating film and including an M2₂ₓO_{(2y-1)} type oxide; a third insulating film surrounding the second insulating film and including an M3ₓO_{y} type oxide; and a fourth insulating film surrounding the third insulating film. Each of M1, M2 and M3 may be a metal material, and *x* and *y* may each be a natural number.

The sum of thicknesses of the first insulating film, the second insulating film, and the third insulating film may be 10 nm or less.

The fourth insulating film may have a thickness greater than the sum of the thicknesses of the first insulating film, the second insulating film, and the third insulating film.

The thickness of the first insulating film may be greater than the thickness of the second insulating film, and the thickness of the third insulating film may be equal to or greater than the thickness of the second insulating film.

The first insulating film may include an M1O₂ type oxide, the second insulating film may include an M2₂O₃ type oxide, and the third insulating film may include an M3O₂ type oxide.

The first insulating film may include at least one of SiO₂, ZrO₂, HfO₂, GeO₂, TiO₂ and TeO₂, and the second insulating film may include at least one of Al₂O₃, Y₂O₃, La₂O₃, Ce₂O₃, Lu₂O₃, Sc₂O₃ and Yb₂O₃.

The third insulating film may include at least one of SiO₂, ZrO₂, HfO₂, GeO₂, TiO₂, and TeO₂.

The first insulating film may include ZrO₂, the second insulating film may include Al₂O₃, and the third insulating film may include ZrO₂.

The display device may further include a fifth insulating film surrounding the fourth insulating film and having a thickness greater than the thickness of the fourth insulating film.

The fourth insulating film may be an inorganic film including an oxide, and the fifth insulating film may be an inorganic film including an oxide different from a material of the fourth insulating film.

The pixel may further include a first alignment electrode and a second alignment electrode located under the light-emitting element and spaced apart from each other.

Other details of the embodiments are included in the detailed description and the drawings.

### [Effects of the Invention]

A light-emitting element according to embodiments may include a multilayer oxide insulating film surrounding a first semiconductor layer, an active layer, and a second semiconductor layer. The multilayer oxide insulating film may include a first insulating film containing an M1ₓO_{y} type oxide, a second insulating film containing an M2₂ₓO_{(2y-1)} type oxide, and a third insulating film containing an M3ₓO_{y} type oxide.

According to embodiments, oxygen flowing into the light-emitting element may be captured by oxygen vacancies formed at interfaces of the first, second, and third insulating films. Accordingly, the reliability of the light-emitting element can be increased.

A display device according to embodiments may include a pixel including the light-emitting element. Accordingly, the reliability of the display device can be increased.

However, the effects of the embodiments are not limited to the aforementioned effects, and various other effects are included in the present specification.

### [Brief Description of the Drawings]

FIG. 1 is a schematic perspective view of a light-emitting element according to an embodiment;
FIG. 2 is a schematic cross-sectional view of the light-emitting element according to the embodiment;
FIG. 3 is a cross-sectional view of a light-emitting element according to an embodiment;
FIG. 4 is a cross-sectional view of a light-emitting element according to an embodiment;
FIG. 5 illustrates an interface reaction occurring in a multilayer oxide insulating film according to an embodiment and resultant oxygen vacancies;
FIG. 6 is a graph showing the luminance maintenance rate of a light-emitting element with respect to the material that forms a multilayer oxide insulating film;
FIG. 7 is a graph showing the luminance maintenance rate of a light-emitting element with respect to the thickness of a first insulating film;
FIG. 8 is a graph showing the luminance maintenance rate of a light-emitting element with respect to the thickness of a second insulating film;
FIG. 9 is a graph showing the luminance maintenance rate of a light-emitting element with respect to the thickness of a third insulating film;
FIG. 10 is a plan view of a display device according to an embodiment;
FIG. 11 is a circuit diagram of a pixel according to an embodiment;
FIG. 12 is a circuit diagram of a pixel according to an embodiment;
FIG. 13 is a plan view of a pixel according to an embodiment;
FIG. 14 is a cross-sectional view of a display device according to an embodiment;
FIG. 15 is an enlarged view of an area of a pixel illustrated in FIG. 14;
FIG. 16 is an enlarged view of an area of a light-emitting element illustrated in FIG. 15; and
FIG. 17 is an enlarged view of an area of the light-emitting element illustrated in FIG. 15.

### [Mode for Invention]

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being "on" another element or layer, the element or layer can be directly on another element or layer or intervening elements or layers. Like reference numerals refer to like elements throughout the specification. Shapes, sizes, ratios, angles, numbers, etc. disclosed in the drawings for describing embodiments are merely an example, and the present disclosure is not limited to the illustrated details.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, specific embodiments will be described with reference to the accompanying drawings.

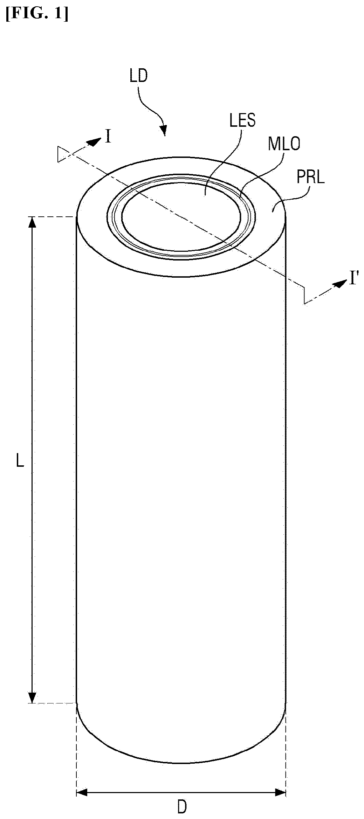

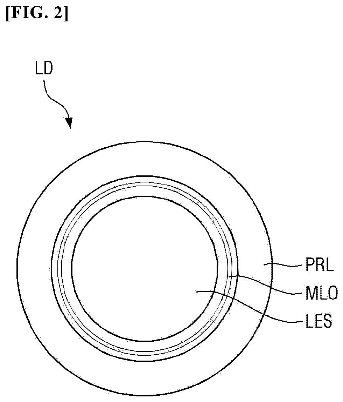

FIG. 1 is a schematic perspective view of a light-emitting element LD according to an embodiment. FIG. 2 is a schematic cross-sectional view of the light-emitting element LD according to the embodiment. For example, FIG. 2 schematically shows a cross-section of the light-emitting element LD of FIG. 1.

Referring to FIGS. 1 and 2, the light-emitting element LD may include a light-emitting stack LES, a multilayer oxide insulating film MLO, and a protective film PRL. In an embodiment, the light-emitting element LD may be provided in a rod shape. In the description of embodiments, the rod shape may include various rod-like shapes or bar-like shapes including a cylindrical shape or a polygonal column shape, and the shape of the cross-section of the light-emitting element LD is not particularly limited. In an embodiment, a length L of the light-emitting element LD may be greater than a diameter D (or a width of the cross-section) of the light-emitting element LD.

The light-emitting stack LES (also referred to as a "light-emitting body" or a "light-emitting structure") may include semiconductor layers of different conductivity types and an active layer located between the semiconductor layers. The light-emitting stack LES may optionally further include at least one electrode layer.

The multilayer oxide insulating film MLO may surround an outer peripheral surface of the light-emitting stack LES (e.g., a side surface of the rod-shaped light-emitting stack LES). The multilayer oxide insulating film MLO may expose both ends of the light-emitting stack LES (e.g., two bases of the rod-shaped light-emitting stack LES). The multilayer oxide insulating film MLO may include two or more insulating films containing different oxides. The two or more insulating films may be thin films having a small thickness. For example, the multilayer oxide insulating film MLO may include insulating films, the sum of whose thicknesses is 10 nm or less. Since the thickness of the multilayer oxide insulating film MLO is limited to 10 nm or less, the influence of the multilayer oxide insulating film MLO on the characteristics of the light-emitting stack LES can be prevented or reduced.

The protective film PRL may surround the multilayer oxide insulating film MLO and expose both ends of the light-emitting stack LES (e.g., two bases of the rod-shaped light-emitting stack LES). The protective film PRL may be a single insulating film or may include two or more insulating films.

The protective film PRL may be formed to stably protect the light-emitting stack LES and the multilayer oxide insulating film MLO in a process of manufacturing the light-emitting element LD and/or in other subsequent processes (e.g., a pixel process for forming a pixel of a display device using the light-emitting element LD). For example, the protective film PRL may be formed to a thickness that allows it to remain on the surface of the light-emitting element LD even when it is etched by a certain thickness due to over-etching, which may occur in a process of etching upper surfaces of the multilayer oxide insulating film MLO and the protective film PRL during the process of manufacturing the light-emitting element LD and/or in a pixel process for forming a pixel of a display device using the light-emitting element LD (e.g., an etching process for forming pixel electrodes connected to both ends of the light-emitting element LD).

For example, the protective film PRL may be formed to a thickness including a margin for over-etching that may occur in a subsequent process, so that it can stably cover the light-emitting stack LES and the multilayer oxide insulating film MLO. In an embodiment, the protective film PRL may include at least one insulating film having a thickness (e.g., a thickness of about 10 nm or greater) equal to or greater than the thickness of the multilayer oxide insulating film MLO.

In an embodiment, the light-emitting element LD may have a small size in the range of nanometers to micrometers. For example, the light-emitting element LD may have the diameter D (or the width of the cross-section) and/or the length L in the range of nanometers to micrometers. For example, the light-emitting element LD may have the diameter D and/or the length L in the range of about tens of nanometers to tens of micrometers.

The structure, shape, size, and/or type of the light-emitting element LD may vary depending on embodiments. For example, the structure, shape, size, and/or type of the light-emitting element LD may be variously changed according to design conditions of a light-emitting device using the light-emitting element LD or light-emitting characteristics to be secured.

The light-emitting device including the light-emitting element LD may be used in various types of devices that require a light source. For example, light-emitting elements LD may be placed in a pixel of a display device and may be used as a light source of the pixel. The light-emitting element LD may also be used in other types of devices that require a light source, such as a lighting device.

In an embodiment, the light-emitting elements LD may be surface-treated using a hydrophobic material. Accordingly, when the light-emitting elements LD are supplied to each emission area (e.g., an emission area of each pixel and/or subpixel) using an inkjet method or the like, the agglomeration of the light-emitting elements LD can be prevented.

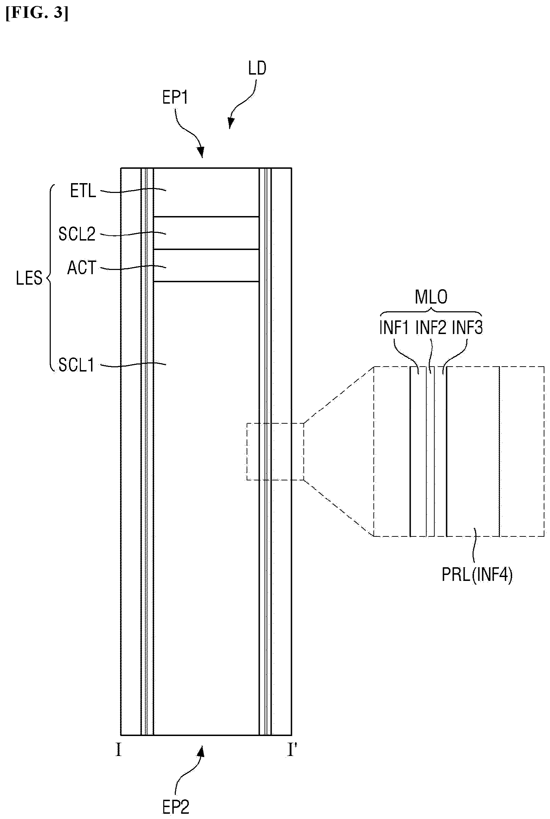

FIG. 3 is a cross-sectional view of a light-emitting element LD according to an embodiment. For example, FIG. 3 shows an embodiment of a cross-section (e.g., a longitudinal section) of the light-emitting element LD corresponding to line I-I' of FIG. 1.

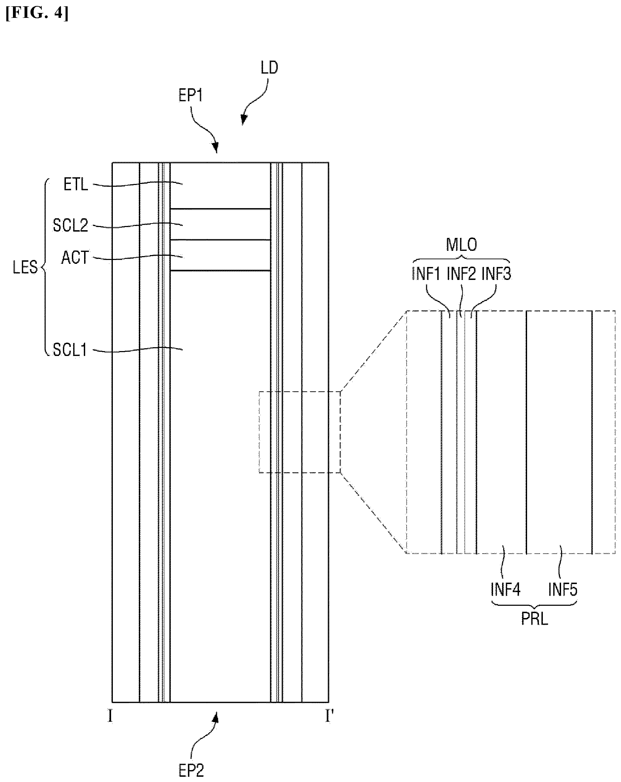

FIG. 4 is a cross-sectional view of a light-emitting element LD according to an embodiment. For example, FIG. 4 shows another embodiment of the cross-section of the light-emitting element LD corresponding to line I-I' of FIG. 1. Compared to the embodiment of FIG. 3, in the embodiment of FIG. 4, the light-emitting element LD further includes a fifth insulating film INF5.

Referring to FIGS. 3 and 4 in addition to FIGS. 1 and 2, a light-emitting element LD may include a light-emitting stack LES including a first semiconductor layer SCL1, an active layer ACT (also referred to as a "light-emitting layer"), and a second semiconductor layer SCL2 which are sequentially arranged and/or stacked along one direction (e.g., a longitudinal direction or a height direction). The light-emitting stack LES may optionally further include an electrode layer ETL. The light-emitting element LD may further include a multilayer oxide insulating film MLO and a protective film PRL surrounding the light-emitting stack LES.

The light-emitting element LD may include a first end EP1 and a second end EP2. In an embodiment, the first end EP1 and the second end EP2 may be opposite each other. For example, the light-emitting element LD may include the first end EP1 and the second end EP2 at both ends in the longitudinal direction (or height direction). The first end EP1 of the light-emitting element LD may include a first base (e.g., an upper surface) of the light-emitting element LD and/or an area around the first base. The second end EP2 of the light-emitting element LD may include a second base (e.g., a lower surface) of the light-emitting element LD and/or an area around the second base.

In an embodiment, the first semiconductor layer SCL1, the active layer ACT, the second semiconductor layer SCL2, and the electrode layer ETL may be sequentially arranged in a direction from the second end EP2 of the light-emitting element LD toward the first end EP1. For example, the electrode layer ETL (or the second semiconductor layer SCL2) may be located at the first end EP1 of the light-emitting element LD, and the first semiconductor layer SCL1 (or another electrode layer adjacent to the first semiconductor layer SCL1 and electrically connected to the first semiconductor layer SCL1) may be located at the second end EP2 of the light-emitting element LD.

In the embodiment of FIG. 3, the electrode layer ETL is described as being included in the light-emitting stack LES. However, embodiments are not limited to this case. For example, the electrode layer ETL may also be formed separately from the light-emitting stack LES and then placed on the light-emitting stack LES.

In an embodiment, the light-emitting stack LES (or the light-emitting element LD including the light-emitting stack LES) may further include at least one other semiconductor layer (e.g., at least one other semiconductor layer located on and/or under the active layer ACT) and/or at least one other electrode layer (e.g., an additional electrode layer located around the first semiconductor layer SCL1).

The first semiconductor layer SCL1 may include a first conductivity type semiconductor layer containing a first conductivity type dopant. For example, the first semiconductor layer SCL1 may be an N-type semiconductor layer containing an N-type dopant.

In an embodiment, the first semiconductor layer SCL1 may contain a nitride-based semiconductor material or a phosphide-based semiconductor material. For example, the first semiconductor layer SCL1 may contain a nitride-based semiconductor material including at least one of GaN, AlGaN, InGaN, AlInGaN, AlN and InN or a phosphide-based semiconductor material including at least one of GaP, GaInP, AlGaP, AlGaInP, AlP and InP. The first semiconductor layer SCL1 may also contain other materials.

In an embodiment, the first semiconductor layer SCL1 may contain an N-type dopant such as Si, Ge, or Sn. The first semiconductor layer SCL1 may also contain other dopants.

The active layer ACT (also referred to as a "light-emitting layer") may be located on the first semiconductor layer SCL1. The active layer ACT may include a single or multiple quantum well (QW) structure. When a voltage equal to or higher than a threshold voltage is applied to both ends of the light-emitting element LD, electron-hole pairs may recombine in the active layer ACT. Accordingly, light may be emitted from the light-emitting element LD.

In an embodiment, the active layer ACT may emit light in a visible light wavelength band, for example, light in a wavelength band of about 400 to 900 nm. For example, the active layer ACT may emit blue light having a peak wavelength in the range of about 440 to 480 nm, green light having a peak wavelength in the range of about 510 to 550 nm, or red light having a peak wavelength in the range of about 610 to 650 nm. The active layer ACT may also emit light of other colors and/or wavelength bands in addition to the colors and/or wavelength bands exemplified above.

In an embodiment, the active layer ACT may contain a nitride-based semiconductor material or a phosphide-based semiconductor material. For example, the active layer ACT may contain a nitride-based semiconductor material including at least one of GaN, AlGaN, InGaN, InGaAlN, AlN, InN and AlInN or a phosphide-based semiconductor material including at least one of GaP, GaInP, AlGaP, AlGaInP, AlP and InP. The active layer ACT may also contain other materials.

The second semiconductor layer SCL2 may be located on the active layer ACT. The second semiconductor layer SCL2 may include a second conductivity type semiconductor layer containing a second conductivity type dopant. For example, the second semiconductor layer SCL2 may be a P-type semiconductor layer containing a P-type dopant.

In an embodiment, the second semiconductor layer SCL2 may contain a nitride-based semiconductor material or a phosphide-based semiconductor material. For example, the second semiconductor layer SCL2 may contain a nitride-based semiconductor material including at least one of GaN, AlGaN, InGaN, AlInGaN, AlN and InN or a phosphide-based semiconductor material including at least one of GaP, GaInP, AlGaP, AlGaInP, AlP and InP. The second semiconductor layer SCL2 may also contain other materials.

In an embodiment, the second semiconductor layer SCL2 may contain a P-type dopant such as Mg. The second semiconductor layer SCL2 may also contain other dopants.

In an embodiment, the first semiconductor layer SCL1 and the second semiconductor layer SCL2 may contain the same semiconductor material (e.g., the same nitride-based semiconductor material), but may contain dopants of different conductivity types. In another embodiment, the first semiconductor layer SCL1 and the second semiconductor layer SCL2 may contain different semiconductor materials and may contain dopants of different conductivity types.

In an embodiment, the first semiconductor layer SCL1 and the second semiconductor layer SCL2 may have different lengths (or thicknesses) in the longitudinal direction of the light-emitting element LD. For example, the first semiconductor layer SCL1 may have a longer length (or a thicker thickness) than the second semiconductor layer SCL2 along the longitudinal direction of the light-emitting element LD. Accordingly, the active layer ACT may be located closer to the first end EP1 (e.g., a P-type end) than to the second end EP2 (e.g., an N-type end).

The electrode layer ETL may be located on the second semiconductor layer SCL2. The electrode layer ETL may be an electrode for protecting the second semiconductor layer SCL2 and smoothly connecting the second semiconductor layer SCL2 to at least one circuit element, electrode, and/or wiring. For example, the electrode layer ETL may be an ohmic contact electrode or a Schottky contact electrode.

According to an embodiment, the electrode layer ETL may contain a metal or a metal oxide. For example, the electrode layer ETL may be formed by using a metal, such as chromium (Cr), titanium (Ti), aluminium (Al), gold (Au), nickel (Ni) or copper (Cu), an oxide or alloy thereof, or a transparent conductive material, such as indium tin oxide (ITO), indium zinc oxide (IZO), indium tin zinc oxide (ITZO), zinc oxide (ZnO) or indium oxide (In₂O₃), alone or in combination. The electrode layer ETL may also contain other materials.

In an embodiment, the electrode layer ETL may be substantially transparent. Accordingly, light generated by the light-emitting element LD may pass through the electrode layer ETL.

The multilayer oxide insulating film MLO may surround the light-emitting stack LES. For example, the multilayer oxide insulating film MLO may surround outer peripheral surfaces (e.g., side surfaces) of at least the first semiconductor layer SCL1, the active layer ACT, and the second semiconductor layer SCL2. In an embodiment in which the light-emitting element LD further includes the electrode layer ETL, the multilayer oxide insulating film MLO may selectively surround the electrode layer ETL. For example, the multilayer oxide insulating film MLO may partially or entirely surround the outer peripheral surface (e.g., side surface) of the electrode layer ETL or may not surround the electrode layer ETL.

The multilayer oxide insulating film MLO may expose the electrode layer ETL (or the second semiconductor layer SCL2) and the first semiconductor layer SCL1 (or another electrode layer provided at the second end EP2 of the light-emitting element LD) at the first end EP1 and the second end EP2 of the light-emitting element LD, respectively. For example, the multilayer oxide insulating film MLO may not be provided on the two bases (e.g., the upper surface and the lower surface of the light-emitting element LD) corresponding to the first and second ends EP1 and EP2 of the light-emitting element LD. Accordingly, an electrical signal (e.g., a driving signal and/or a power voltage) may be applied to the light-emitting element LD through the first end EP1 and the second end EP2 of the light-emitting element LD.

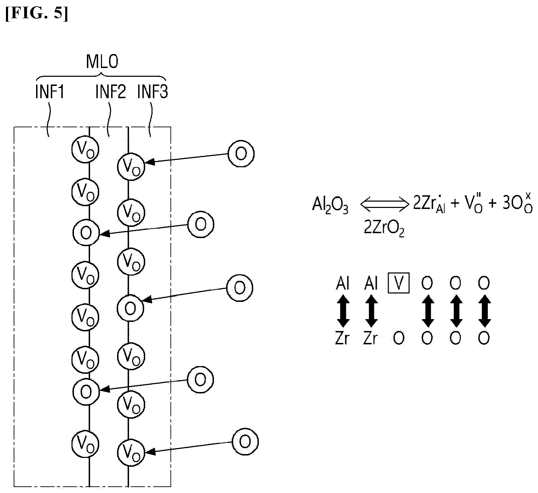

The multilayer oxide insulating film MLO may be provided on the surface of the light-emitting stack LES to secure the electrical stability of the light-emitting element LD. In addition, the multilayer oxide insulating film MLO may slow down the deterioration of the light-emitting element LD and increase the reliability of the light-emitting element LD by blocking or reducing the introduction of oxygen into the light-emitting stack LES. For example, the multilayer oxide insulating film MLO may include oxygen vacancies (e.g., oxygen vacancies V_{O} in FIG. 5) formed at an interface between insulating films containing different oxides. Since oxygen is captured by the oxygen vacancies, the introduction of oxygen into the light-emitting stack LES can be blocked or reduced.

The multilayer oxide insulating film MLO may include a first insulating film INF1, a second insulating film INF2, and a third insulating film INF3.

The first insulating film INF1 may surround the light-emitting stack LES. For example, the first insulating film INF1 may surround the outer peripheral surfaces (e.g., side surfaces) of the first semiconductor layer SCL1, the active layer ACT, and the second semiconductor layer SCL2. In an embodiment, the first insulating film INF1 may further surround at least a portion (e.g., at least a portion of a side surface) of the electrode layer ETL.

The second insulating film INF2 may surround the first insulating film INF1. For example, the second insulating film INF2 may surround an outer peripheral surface (e.g., a side surface) of the first insulating film INF1.

The third insulating film INF3 may surround the second insulating film INF2. For example, the third insulating film INF3 may surround an outer peripheral surface (e.g., a side surface) of the second insulating film INF2.

The first insulating film INF1, the second insulating film INF2, and the third insulating film INF3 may contain an oxide that can generate enough oxygen vacancies at their interfaces to improve deterioration of the light-emitting element LD while reducing or minimizing defects in the light-emitting element LD. For example, the first insulating film INF1 may contain an M1ₓO_{y} type (or MₓO_{y} type) oxide (e.g., an M1ₓO_{y} type metal oxide), the third insulating film INF3 may contain an M3ₓO_{y} type (or MₓO_{y} type) oxide (e.g., an M3ₓO_{y} type metal oxide), and the second insulating film INF2 may contain an M2₂ₓO_{(2y-1)} type (or M₂ₓO_{(2y-1)} type) oxide (e.g., an M2₂ₓO_{(2y-1)} type metal oxide). Here, M or M1, M2 and M3 may each be a material that bonds with oxygen (or an oxygen ion), for example, a metal material (or a metal ion), and *x* and *y* may each be a natural number. At least two of M1, M2, and M3 may be the same material, or M1, M2 and M3 may be different materials. For example, M1 and M3 may be the same material, and M2 may be a different material from M1 and M3, but embodiments are not limited to this example.

In an embodiment, oxides used to form the first insulating film INF1, the second insulating film INF2, and the third insulating film INF3 may be materials selected to generate enough oxygen vacancies at their interfaces to improve deterioration of the light-emitting element LD while reducing or minimizing defects in the light-emitting element LD. For example, the first insulating film INF1 and the third insulating film INF3 may contain an M1O₂ type oxide and an M3O₂ type oxide, respectively, and the second insulating film INF2 may contain an M2₂O₃ type oxide.

In an embodiment, each of the first insulating film INF1 and the third insulating film INF3 may contain at least one of silicon oxide, zirconium oxide, hafnium oxide, germanium oxide, titanium oxide, and tellurium oxide. For example, each of the first insulating film INF1 and the third insulating film INF3 may contain at least one of SiO₂, ZrO₂, HfO₂, GeO₂, TiO₂, and TeO₂. The first insulating film INF1 and the third insulating film INF3 may contain the same oxide or different oxides.

In an embodiment, the second insulating film INF2 may contain at least one of aluminium oxide, yttrium oxide, lanthanum oxide, cerium oxide, lutetium oxide, scandium oxide, and ytterbium oxide. For example, the second insulating film INF2 may contain at least one of Al₂O₃, Y₂O₃, La₂O₃, Ce₂O₃, Lu₂O₃, Sc₂O₃, and Yb₂O₃.

In an embodiment, the first insulating film INF1 may be an oxide insulating film containing ZrO₂, the second insulating film INF2 may be an oxide insulating film containing Al₂O₃, and the third insulating film INF3 may be an oxide insulating film containing ZrO₂. In this case, it is possible to secure oxygen vacancies for improving deterioration while reducing or minimizing defects in the light-emitting element LD. The oxides used to form the first insulating film INF1, the second insulating film INF2, and the third insulating film INF3 are not limited to the above example and may vary depending on embodiments.

In an embodiment, the first insulating film INF1, the second insulating film INF2, and the third insulating film INF3 may be formed as thin films so that their influence on the light-emitting stack LES can be reduced or minimized. For example, the sum of thicknesses of the first insulating film INF1, the second insulating film INF2, and the third insulating film INF3 may be 10 nm or less. In addition, the first insulating film INF1, the second insulating film INF2, and the third insulating film INF3 may be formed to a limited thickness so as to smoothly induce an interface reaction that generates enough oxygen vacancies at their interfaces to improve deterioration of the light-emitting element LD while reducing or minimizing defects in the light-emitting element LD.

For example, the second insulating film INF2 may be formed to a thickness of, but not limited to, 2 nm or less (e.g., a thickness of about 1 to 2 nm) to smoothly induce an interface reaction. The first insulating film INF1 may be formed to have a greater thickness than the second insulating film INF2 to prevent the occurrence of a defect in an area too close to the light-emitting stack LES (e.g., to secure a certain distance or more between the interface of the first and second insulating films INF1 and INF2 and the light-emitting stack LES), but may be formed to have a limited thickness to reduce or minimize its influence on the light-emitting stack LES. For example, the first insulating film INF1 may be formed to a thickness of, but not limited to, 3 nm or less (e.g., a thickness of about 2 to 3 nm). The third insulating film INF3 may be formed to a thickness equal to or greater than the thickness of the second insulating film INF2 to allow an interface reaction to occur relatively uniformly at the interface between the first insulating film INF1 and the second insulating film INF2 and at the interface between the second insulating film INF2 and the third insulating film INF3 (e.g., to prevent the interface reaction from being concentrated at the interface between the first insulating film INF1 and the second insulating film INF2). For example, the third insulating film INF3 may be formed to a thickness of, but not limited to, 2 nm or 3 nm or less (e.g., a thickness of about 1 to 3 nm). Accordingly, it is possible to improve the deterioration characteristics of the light-emitting element LD while reducing or minimizing defects in the light-emitting element LD. As a result, the reliability of the light-emitting element LD can be increased.

The protective film PRL may surround the multilayer oxide insulating film MLO. For example, the protective film PRL may surround the third insulating film INF3 and expose the first end EP1 and the second end EP2 of the light-emitting element LD.

The protective film PRL may include at least one insulating film. For example, the protective film PRL may include a fourth insulating film INF4 (or a first protective film).

The fourth insulating film INF4 may surround the multilayer oxide insulating film MLO. For example, the fourth insulating film INF4 may surround an outer peripheral surface (e.g., a side surface) of the third insulating film INF3.

In an embodiment, the protective film PRL may include only the fourth insulating film INF4 as in the embodiment of FIG. 3. The fourth insulating film INF4 may be formed to have a material and/or thickness that can stably protect the light-emitting stack LES and the multilayer oxide insulating film MLO in the process of manufacturing the light-emitting element LD and/or in other subsequent processes (e.g., an etching process included in the pixel process of a display device using the light-emitting element LD). For example, the fourth insulating film INF4 may be an inorganic film containing an oxide (e.g., an inorganic film containing silicon oxide, silicon nitride, silicon oxynitride, aluminium oxide, or titanium oxide) and may have a thickness (e.g., a thickness of about 10 nm or more) greater than the sum of the thicknesses of the first insulating film INF1, the second insulating film INF2 and the third insulating film INF3. For example, the fourth insulating film INF4 may be an inorganic film containing SiO₂ or other oxides and may have a thickness of about 10 to 200 nm, but embodiments are not limited to this example.

In an embodiment, the protective film PRL may include two insulating films including a fourth insulating film INF4 and a fifth insulating film INF5 (or a second protective film) as in the embodiment of FIG. 4.

The fifth insulating film INF5 may surround the fourth insulating film INF4. For example, the fifth insulating film INF5 may surround an outer peripheral surface (e.g., a side surface) of the fourth insulating film INF4.

The fifth insulating film INF5 may protect the light-emitting stack LES and the multilayer oxide insulating film MLO together with the fourth insulating film INF4. For example, the fifth insulating film INF5 may be formed to have a material and/or thickness that can stably protect the light-emitting stack LES and the multilayer oxide insulating film MLO in the process of manufacturing the light-emitting element LD and/or in other subsequent processes (e.g., an etching process for forming pixel electrodes on the light-emitting element LD). For example, the fifth insulating film INF5 may be an inorganic film containing an oxide (e.g., an inorganic film containing silicon oxide, silicon nitride, silicon oxynitride, aluminium oxide, or titanium oxide) different from the material of the fourth insulating film INF4 and may have a greater thickness than the fourth insulating film INF4. For example, the fifth insulating film INF5 may be an inorganic film containing Al₂O₃ or other oxides and may have a thickness of about 10 to 200 nm, but embodiments are not limited to this example.

The structure, material, and/or thickness of the protective film PRL are not limited to the above-described embodiments. For example, the protective film PRL may also include three or more insulating films including one or more additional insulating films in addition to the fourth insulating film INF4 and the fifth insulating film INF5.

In the case that the protective film PRL is formed to have two or more insulating films including the fourth insulating film INF4 and the fifth insulating film INF5, the thickness of each insulating film constituting the protective film PRL may be reduced. Accordingly, a process time for forming the protective film PRL can be reduced, and process efficiency can be increased. For example, when the protective film PRL is formed using atomic layer deposition (ALD) process technology, the ALD process time can be reduced by reducing the thickness of each insulating film constituting the protective film PRL.

FIG. 5 illustrates an interface reaction occurring in a multilayer oxide insulating film MLO according to an embodiment and resultant oxygen vacancies V_{O}. For example, FIG. 5 shows an interface reaction occurring in a multilayer oxide insulating film MLO, which includes a first insulating film INF1 containing ZrO₂, a second insulating film INF2 containing Al₂O₃ and a third insulating film INF3 containing ZrO₂, and resultant oxygen vacancies Vo.

Referring to FIG. 5 in addition to FIGS. 1 through 4, the oxygen vacancies V_{O} may be formed by an interface reaction at interfaces of the second insulating film INF2 with the first insulating film INF1 and the third insulating film INF3. For example, at the above interfaces, Al₂O₃ of the second insulating film INF2 may react with ZrO₂ of the first insulating film INF1 and ZrO₂ of the third insulating film INF3 to form the oxygen vacancies V_{O}.

For example, at the above interfaces, aluminium (Al) and zirconium (Zr) may be substituted for each other, and oxygen (O) may be substituted for each other. For example, at the interfaces of the second insulating film INF2 with the first insulating film INF1 and the third insulating film INF3, Al₂O₃ of the second insulating film INF2 may react with 2ZrO₂ (ZrO₂ of the first insulating film INF1 and ZrO₂ of the third insulating film INF3) of the first and third insulating films INF1 and INF3 as disclosed in a chemical formula of FIG. 5. Therefore, zirconium (Zr) may take the place of aluminium (Al), and oxygen (O) may be substituted for each other.

The chemical formula disclosed in FIG. 5 describes defects occurring at the interfaces according to Kroger-Vink notation, where a subscript indicates the site of a defect, and a superscript indicates the amount of charge. For example, Zr^{·}_{A1} represents a zirconium (Zr) ion sitting on an aluminium (Al) lattice site, with single positive charge, and V"_{O} represents an oxygen vacancy V_{O} sitting on an oxygen (O) site, with double negative charge. Three oxygen (O) ions occupy three of the four oxygen (O) sites, and one oxygen (O) site is empty to become an oxygen vacancy Vo. The superscript X in O^{X}_{O} indicates that the relative charge is zero.

For example, at the interfaces of the second insulating film INF2 with the first and third insulating films INF1 and INF3, the ratio of oxygen (O) ions of the first and third insulating films INF1 and INF3 to oxygen (O) ions of the second insulating film INF2 is 4:3. Therefore, the oxygen vacancies Vo may be formed at the interfaces. The oxygen vacancies V_{O} formed by the interface reaction are defects fixed to adjacent atoms and may not move even when a light-emitting element LD is driven.

The oxygen vacancies V_{O} formed at the interfaces may function as capture sites that capture oxygen (O) flowing into the light-emitting element LD, thereby suppressing the diffusion of oxygen. Accordingly, the deterioration of the light-emitting element LD can be reduced or minimized, and the reliability of the light-emitting element LD can be increased.

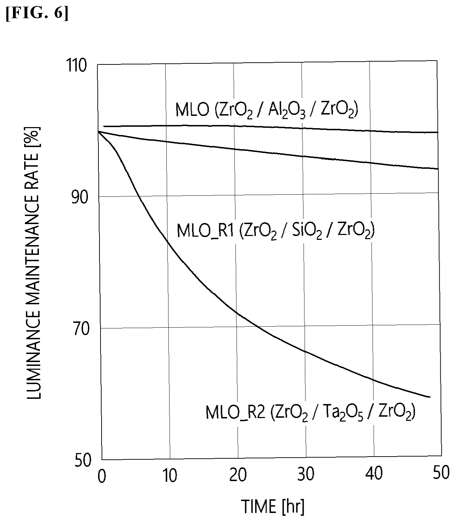

FIG. 6 is a graph showing the luminance maintenance rate of a light-emitting element LD with respect to the material that forms a multilayer oxide insulating film MLO. For example, FIG. 6 shows the luminance maintenance rate of a light-emitting element LD including a multilayer oxide insulating film MLO which includes a first insulating film INF1 containing ZrO₂, a second insulating film INF2 containing Al₂O₃ and a third insulating film INF3 containing ZrO₂ and the luminance maintenance rates of light-emitting elements LD including multilayer oxide insulating films MLO_R1 and MLO_R2 in which the material of the second insulating film INF2 is changed to an oxide other than an M₂O₃ type oxide.

Referring to FIG. 6 in addition to FIGS. 1 through 5, the light-emitting element LD including the multilayer oxide insulating film MLO which includes the first insulating film INF1 containing ZrO₂, the second insulating film INF2 containing Al₂O₃, and the third insulating film INF3 containing ZrO₂ may maintain a high luminance maintenance rate even over time. On the other hand, the light-emitting element LD including the multilayer oxide insulating film MLO_R1 in which the second insulating film INF2 is changed to an insulating film containing an MO₂ type (where M is a metal material) oxide (e.g., SiO₂) may show a somewhat lower luminance maintenance rate. In addition, the light-emitting element LD including the multilayer oxide insulating film MLO_R2 in which the second insulating film INF2 is changed to an insulating film containing an M₂O₅ type oxide (e.g., Ta₂O₅) may show a significantly lower luminance maintenance rate.

As described above, the luminance maintenance rate of the light-emitting element LD may vary depending on the material that forms the multilayer oxide insulating film MLO. Accordingly, in embodiments, the first insulating film INF1 and the third insulating film INF3 may each be formed using an MₓO_{y} type oxide (e.g., an M1O₂ type oxide and an M3O₂ type oxide, respectively), and the second insulating film INF2 may be formed using an M₂ₓO_{(2y-1)} type oxide (e.g., an M2₂O₃ type oxide) to improve the deterioration characteristics of the light-emitting element LD and ensure reliability.

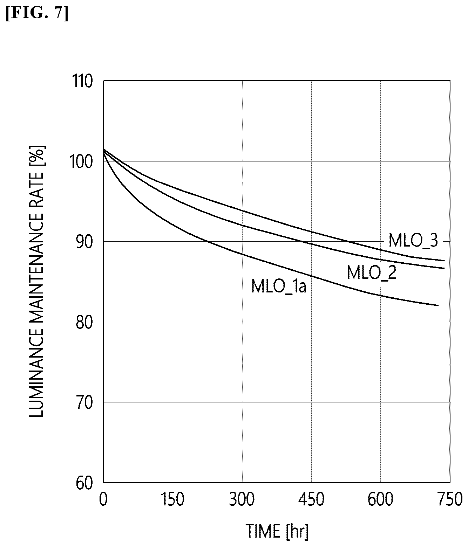

FIG. 7 is a graph showing the luminance maintenance rate of a light-emitting element LD with respect to the thickness of a first insulating film INF1. For example, FIG. 7 shows the luminance maintenance rate of a light-emitting element LD including a multilayer oxide insulating film MLO_1a which includes a first insulating film INF1 containing ZrO₂ and having a thickness of 2 nm, a second insulating film INF2 containing Al₂O₃ and having a thickness of 1 nm and a third insulating film INF3 containing ZrO₂ and having a thickness of 1 nm and the luminance maintenance rates of light-emitting elements LD including multilayer oxide insulating films MLO_2 and MLO_3 in which the thickness of the first insulating film INF1 is changed.

Referring to FIG. 7 in addition to FIGS. 1 through 5, the luminance maintenance rate of the light-emitting element LD may vary depending on the thickness of the first insulating film INF1. For example, the luminance maintenance rate of the light-emitting element LD including the multilayer oxide insulating film MLO_1a which includes the first insulating film INF1 (ZrO₂ insulating film) having a thickness of 2 nm, the luminance maintenance rate of the light-emitting element LD including the multilayer oxide insulating film MLO_2 which includes the first insulating film INF1 (ZrO₂ insulating film) having a thickness of 3 nm, and the luminance maintenance rate of the light-emitting element LD including the multilayer oxide insulating film MLO_3 which includes the first insulating film INF1 (ZrO₂ insulating film) having a thickness of 2.5 nm may be different. Therefore, the luminance maintenance rate of the light-emitting element LD can be controlled or improved by appropriately adjusting the thickness of the first insulating film INF1.

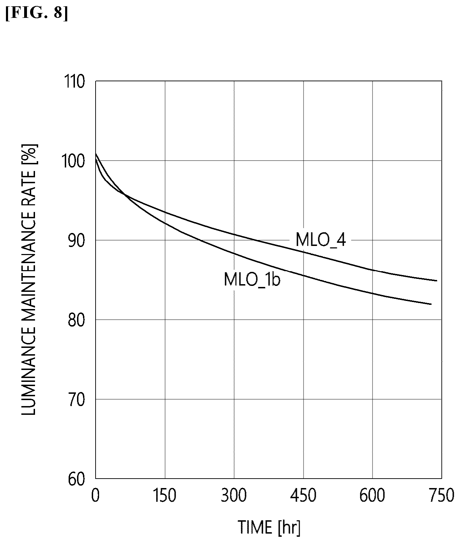

FIG. 8 is a graph showing the luminance maintenance rate of a light-emitting element LD with respect to the thickness of a second insulating film INF2. For example, FIG. 8 shows the luminance maintenance rate of a light-emitting element LD including a multilayer oxide insulating film MLO_1b which includes a first insulating film INF1 containing ZrO₂ and having a thickness of 2 nm, a second insulating film INF2 containing Al₂O₃ and having a thickness of 1 nm and a third insulating film INF3 containing ZrO₂ and having a thickness of 1 nm and the luminance maintenance rate of a light-emitting element LD including a multilayer oxide insulating film MLO_4 in which the thickness of the second insulating film INF2 is changed.

Referring to FIG. 8 in addition to FIGS. 1 through 5, the luminance maintenance rate of the light-emitting element LD may vary depending on the thickness of the second insulating film INF2. For example, the luminance maintenance rate of the light-emitting element LD including the multilayer oxide insulating film MLO_1b which includes the second insulating film INF2 (Al₂O₃ insulating film) having a thickness of 1 nm and the luminance maintenance rate of the light-emitting element LD including the multilayer oxide insulating film MLO_4 which includes the second insulating film INF2 (Al₂O₃ insulating film) having a thickness of 2 nm may be different. Therefore, the luminance maintenance rate of the light-emitting element LD can be controlled or improved by appropriately adjusting the thickness of the second insulating film INF2.

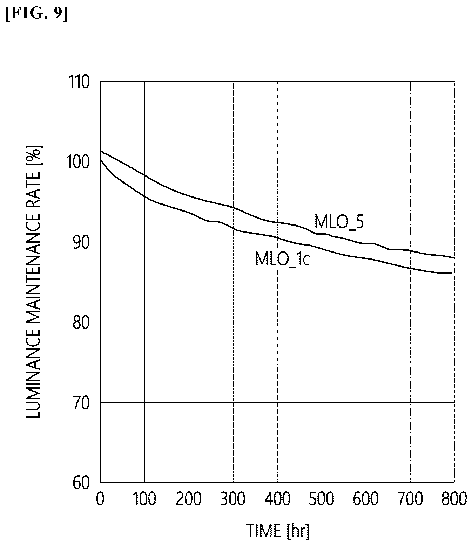

FIG. 9 is a graph showing the luminance maintenance rate of a light-emitting element LD with respect to the thickness of a third insulating film INF3. FIG. 9 shows the luminance maintenance rate of a light-emitting element LD including a multilayer oxide insulating film MLO_1c which includes a first insulating film INF1 containing ZrO₂ and having a thickness of 2 nm, a second insulating film INF2 containing Al₂O₃ and having a thickness of 1 nm and a third insulating film INF3 containing ZrO₂ and having a thickness of 1 nm and the luminance maintenance rate of a light-emitting element LD including a multilayer oxide insulating film MLO_5 in which the thickness of the third insulating film INF3 is changed.

Referring to FIG. 9 in addition to FIGS. 1 through 5, the luminance maintenance rate of the light-emitting element LD may vary depending on the thickness of the third insulating film INF3. For example, the luminance maintenance rate of the light-emitting element LD including the multilayer oxide insulating film MLO_1c which includes the third insulating film INF3 (ZrO₂ insulating film) having a thickness of 1 nm and the luminance maintenance rate of the light-emitting element LD including the multilayer oxide insulating film MLO_5 which includes the third insulating film INF3 (ZrO₂ insulating film) having a thickness of 2 nm may be different. Therefore, the luminance maintenance rate of the light-emitting element LD can be controlled or improved by appropriately adjusting the thickness of the third insulating film INF3.

As described above, the light-emitting element LD may exhibit different characteristics (e.g., different luminance maintenance rates) depending on the thicknesses of the first insulating film INF1, the second insulating film INF2, and the third insulating film INF3. Therefore, the thicknesses of the first insulating film INF1, the second insulating film INF2, and the third insulating film INF3 may be appropriately adjusted in consideration of the characteristics exhibited by the light-emitting element LD.

In FIGS. 7 through 9, the light-emitting elements LD used in each experiment for checking the luminance maintenance rates of the light-emitting elements LD according to the thicknesses of the first insulating film INF, the second insulating film INF2, and the third insulating film INF3 may be different light-emitting elements LD. For example, even in the case of light-emitting elements LD including multilayer oxide insulating films (MLO_la, MLO_1b, MLO_1c) having the same thickness condition, experimental values may be different depending on the difference in the characteristics of the light-emitting elements LD.

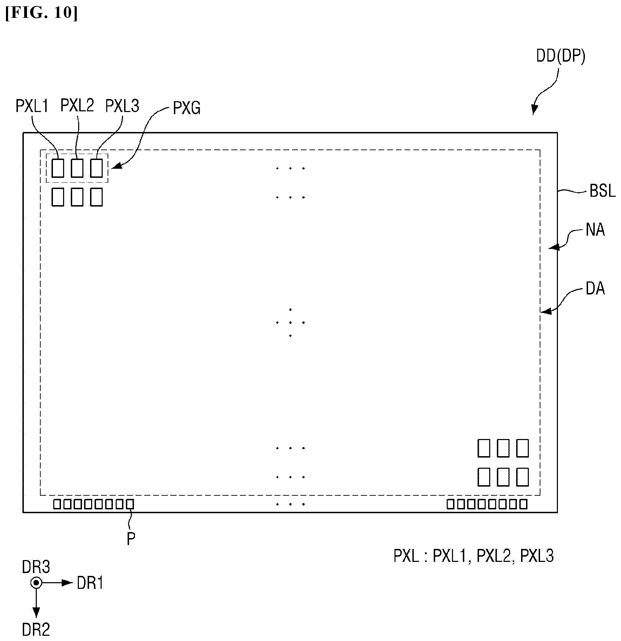

FIG. 10 is a plan view of a display device DD according to an embodiment. FIG. 10 schematically illustrates the structure of the display device DD centering on a display panel DP including a display area DA. The display device DD may further include a driving circuit (e.g., a scan driver, a data driver, and a timing controller) for driving pixels PXL.

Referring to FIG. 10, the display device DD may include a base layer BSL and pixels PXL located on the base layer BSL. The base layer BSL and the display device DD including the base layer BSL may be provided in various shapes. For example, the base layer BSL and the display device DD may be provided in the form of plates having a substantially quadrangular shape in plan view and may include angled or rounded corner portions. The shapes of the base layer BSL and the display device DD can be changed. For example, the base layer BSL and the display device DD may also have other polygonal shapes, such as a hexagon or an octagon, in plan view or may have a shape including a curved perimeter, such as a circle or an oval. In FIG. 10, the display device DD is illustrated as having a quadrangular plate shape.

In FIG. 10, a first direction DR1, a second direction DR2, and a third direction DR3 are shown. In an embodiment, the first direction DR1 may be a widthwise direction (e.g., a row direction or a horizontal direction) of the display device DD, and the second direction DR2 may be a lengthwise direction (e.g., a column direction or a vertical direction) of the display device DD. The third direction DR3 may be a direction intersecting the first direction DR1 and the second direction DR2 and may be, for example, a thickness direction or a height direction of the display device DD.

The base layer BSL may be a base member for forming the display device DD. For example, the base layer BSL may form a base surface of the display device DD. The base layer BSL and the display device DD including the base layer BSL may include the display area DA and a non-display area NA.

The display area DA may be an area where the pixels PXL are arranged and an area where an image is displayed. In an embodiment, the display area DA may be located in a central area of the base layer BSL and the display device DD.

The display area DA may have various shapes. For example, the display area DA may have various shapes including a rectangle, a circle, and an oval. In an embodiment, the display area DA may have a shape corresponding to the shape of the base layer BSL, but embodiments are not limited to this case.

The non-display area NA may be an area excluding the display area DA and may be located around the display area DA. In an embodiment, the non-display area NA may be located in an edge area of the base layer BSL and the display device DD to surround the display area DA. The non-display area NA may include a pad area where pads P are located.

The pixels PXL may be located in the display area DA. For example, the display area DA may include pixel areas where the pixels PXL are located, respectively.

In an embodiment, at least two types of pixels PXL may be arranged in the display area DA to emit light of different colors (or light of different wavelength bands). For example, in the display area DA, first color pixels PXL1, second color pixels PXL2, and third color pixels PXL3 may be arranged. At least one first color pixel PXL1, at least one second color pixel PXL2, and at least one third color pixel PXL3 located adjacent to each other may constitute one pixel group PXG. Each pixel group PXG may emit light of various colors by individually controlling luminances of the first, second and third color pixels PXL1, PXL2 and PXL3.

In the embodiment of FIG. 10, a first color pixel PXL1, a second color pixel PXL2, and a third color pixel PXL3 sequentially arranged along the first direction DR1 may constitute one pixel group PXG. However, the number, type, and/or arrangement structure of the pixels PXL constituting each pixel group PXG may vary depending on embodiments.

In an embodiment, the first color pixel PXL1 may be a red pixel for emitting red light, and the second color pixel PXL2 may be a green pixel for emitting green light. In addition, the third color pixel PXL3 may be a blue pixel for emitting blue light. The color of light emitted from each pixel PXL may also be variously changed.

In an embodiment, each pixel PXL may include at least one light-emitting element LD. For example, a pixel PXL may include a light-emitting element LD according to at least one of the embodiments described with reference to FIGS. 1 through 9. For example, a pixel PXL may include a light-emitting element LD, and the light-emitting element LD may include a light-emitting stack LES including at least a first semiconductor layer SCL1, an active layer ACT and a second semiconductor layer SCL2, a multilayer oxide insulating film MLO including first, second and third insulating films INF1, INF2 and INF3, and a protective film PRL including at least a fourth insulating film INF4. The number, type, structure, and/or size of light-emitting elements LD provided in each pixel PXL may vary depending on embodiments.

In an embodiment, the first color pixel PXL1, the second color pixel PXL2, and the third color pixel PXL3 may include light-emitting elements LD of a first color, a second color and a third color as their light sources, respectively. Accordingly, the first color pixel PXL1, the second color pixel PXL2, and the third color pixel PXL3 may emit light of the first color, light of the second color, and light of the third color, respectively.

In another embodiment, the first color pixel PXL1, the second color pixel PXL2, and the third color pixel PXL3 may include light-emitting elements LD that emit light of the same color, and a light conversion layer including wavelength conversion particles (also referred to as "wavelength shifters") that convert the color and/or wavelength of light, such as quantum dots, quantum rods or phosphors, may be placed in emission areas of the first color pixel PXL1, the second color pixel PXL2, and/or the third color pixel PXL3. Accordingly, the first color pixel PXL1, the second color pixel PXL2, and the third color pixel PXL3 may emit light of the first color, light of the second color, and light of the third color, respectively.

For example, the first color pixel PXL1, the second color pixel PXL2, and the third color pixel PXL3 may include blue light-emitting elements. In this case, a light conversion layer including wavelength conversion particles of the first color (e.g., quantum dots that convert incident light into red light) may be placed in the emission area of the first color pixel PXL1, and a light conversion layer including wavelength conversion particles of the second color (e.g., quantum dots that convert incident light into green light) may be placed in the emission area of the second color pixel PXL2. Accordingly, the first color pixel PXL1 may emit light of the first color (e.g., red light), and the second color pixel PXL2 may emit light of the second color (e.g., green light).

The pixels PXL may have a structure according to at least one of the embodiments described below. For example, the pixels PXL may have a structure to which any one of the embodiments described below is applied or a structure to which a combination of at least two embodiments are applied. However, the structure and type of the pixels PXL are not limited to the embodiments disclosed below.

In an embodiment, the pixels PXL may be active pixels. However, embodiments are not limited to this case. For example, the pixels PXL may also be passive pixels.

Wirings and/or built-in circuits connected to the pixels PXL of the display area DA may be located in the non-display area NA. In addition, the pads P may be located in a part (e.g., the pad area) of the non-display area NA. The pads P may include signal pads and power pads to which driving signals and power voltages necessary for driving the pixels PXL are applied.

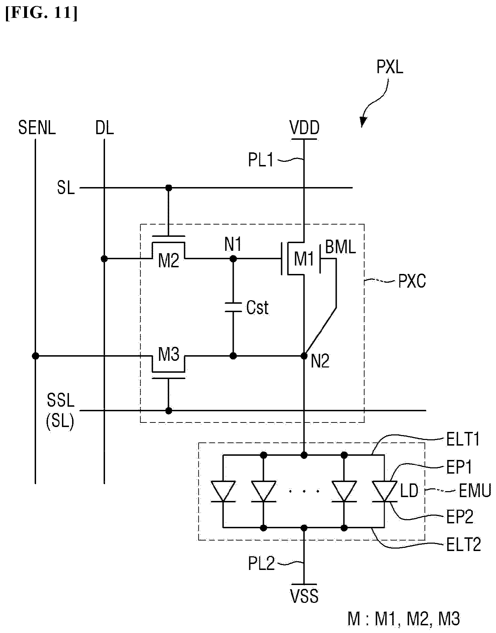

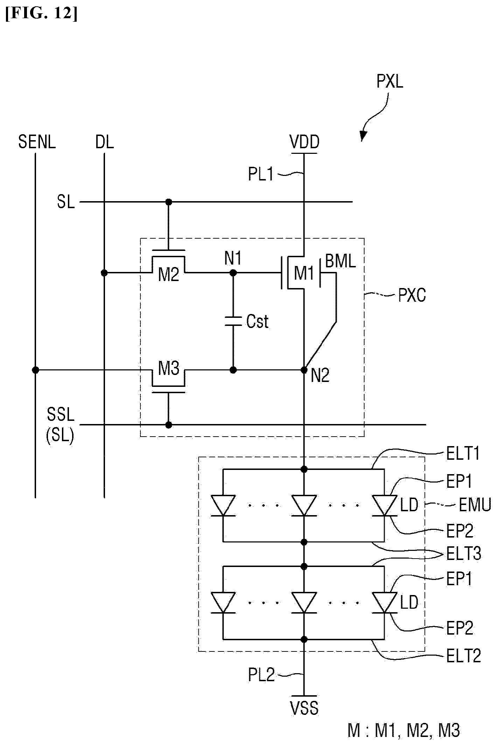

FIG. 11 is a circuit diagram of a pixel PXL according to an embodiment. FIG. 12 is a circuit diagram of a pixel PXL according to an embodiment. For example, FIGS. 11 and 12 show pixels PXL including emission units EMU having different structures.

Each of the pixels PXL illustrated in FIGS. 11 and 12 may be any one of the pixels PXL located in the display area DA of FIG. 6. The pixels PXL of the display area DA may have substantially the same or similar structures.

Referring to FIGS. 11 and 12 in addition to FIGS. 1 through 10, a pixel PXL may be connected to a scan line SL (also referred to as a "first scan line"), a data line DL, a first power line PL1, and a second power line PL2. In addition, the pixel PXL may be further connected to at least one other power line and/or signal line. For example, the pixel PXL may be further connected to a sensing line SENL (also referred to as an "initialization power line") and/or a control line SSL (also referred to as a "second scan line").

The pixel PXL may include an emission unit EMU for generating light of a luminance corresponding to each data signal. In addition, the pixel PXL may further include a pixel circuit PXC for driving the emission unit EMU.

The pixel circuit PXC may be connected to the scan line SL and the data line DL and may be connected between the first power line PL1 and the emission unit EMU. For example, the pixel circuit PXC may be electrically connected to the scan line SL to which a first scan signal is supplied, the data line DL to which a data signal is supplied, the first power line PL1 to which a voltage of a first power supply VDD is applied, and the emission unit EMU.

The pixel circuit PXC may be optionally further connected to the control line SSL to which a second scan signal is supplied and the sensing line SENL which is connected to a reference power supply (or an initialization power supply) or a sensing circuit in a display period or a sensing period. In an embodiment, the second scan signal may be the same as or different from the first scan signal. When the second scan signal is the same as the first scan signal, the control line SSL may be integrated with the scan line SL.

The pixel circuit PXC may include at least one transistor M and a capacitor Cst. For example, the pixel circuit PXC may include a first transistor M1, a second transistor M2, a third transistor M3, and the capacitor Cst.

The first transistor M1 may be connected between the first power line PL1 and a second node N2. The second node N2 may be a node to which the pixel circuit PXC and the emission unit EMU are connected. For example, the second node N2 may be a node where an electrode (e.g., a source electrode) of the first transistor M1 and an electrode (e.g., a first pixel electrode ELT1) of the emission unit EMU are electrically connected to each other. A gate electrode of the first transistor M1 may be connected to a first node N1. The first transistor M1 may be a driving transistor that controls a driving current supplied to the emission unit EMU according to a voltage of the first node N1.

In an embodiment, the first transistor M1 may further include a bottom metal layer BML (also referred to as a "back gate electrode" or a "second gate electrode"). In an embodiment, the bottom metal layer BML may be connected to an electrode (e.g., the source electrode) of the first transistor M1.

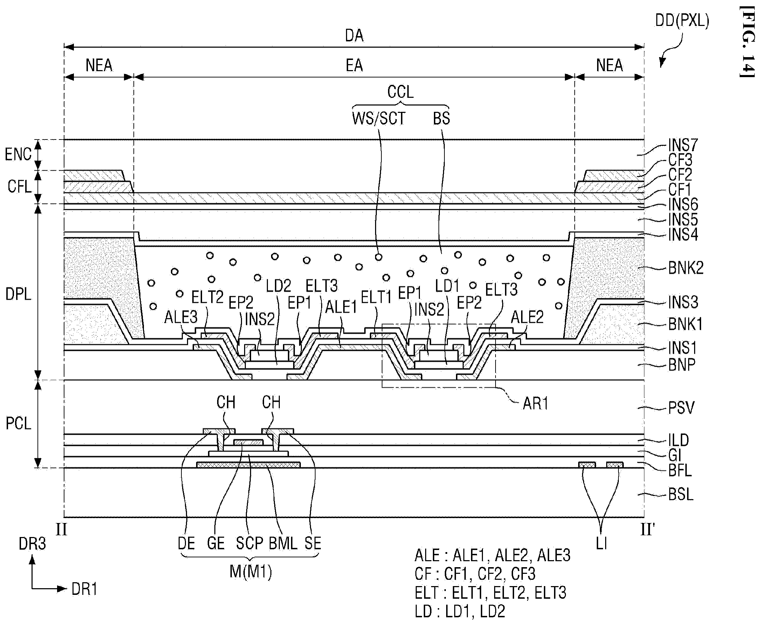

The bottom metal layer BML may be located under a semiconductor pattern (e.g., a semiconductor pattern SCP of FIG. 14) that forms a channel of the first transistor M1. In this case, the bottom metal layer BML may block light from entering the semiconductor pattern, thereby stabilizing the operating characteristics of the first transistor M1.

The second transistor M2 may be connected between the data line DL and the first node N1. In addition, a gate electrode of the second transistor M2 may be connected to the scan line SL. The second transistor M2 may be turned on when the first scan signal of a gate-on voltage (e.g., a logic-high voltage or a high-level voltage) is supplied from the scan line SL and may connect the data line DL and the first node N1.

In each frame period of the display period, a data signal of a corresponding frame may be supplied to the data line DL. The data signal may be transmitted to the first node N1 through the second transistor M2 during a period in which the first scan signal of the gate-on voltage is supplied.

The capacitor Cst may be connected between the first node N1 and the second node N2. The capacitor Cst may be charged with a voltage corresponding to the data signal supplied to the first node N1.

The third transistor M3 may be connected between the second node N2 and the sensing line SENL. Additionally, a gate electrode of the third transistor M3 may be connected to the control line SSL (or the scan line SL). The third transistor M3 may be turned on when the second scan signal (or the first scan signal) of a gate-on voltage (e.g., a logic-high voltage or a high-level voltage) is supplied from the control line SSL and may transmit a reference voltage or an initialization voltage, which is supplied to the sensing line SENL, to the second node N2 or transmit a voltage of the second node N2 to the sensing line SENL. In an embodiment, the voltage of the second node N2 may be transmitted to the sensing circuit through the sensing line SENL and may be provided to the driving circuit (e.g., the timing controller) and used to compensate for a difference in the characteristics of the pixels PXL.

Although all of the transistors M included in the pixel circuit PXC are N-type transistors in FIGS. 11 and 12, embodiments are not limited to this case. For example, at least one of the first, second and third transistors M1, M2 and M3 may be changed to a P-type transistor. In addition, the structure and driving method of the pixel PXL may vary depending on embodiments.

The emission unit EMU may include at least one light-emitting element LD connected (e.g., forward-connected) between the first power supply VDD and a second power supply VSS. The at least one light-emitting element LD may be a light source of the pixel PXL.

In an embodiment, the emission unit EMU may include a single light-emitting element LD forward-connected between the first power supply VDD and the second power supply VSS. In another embodiment, the emission unit EMU may include at least two light-emitting elements LD forward-connected between the first power supply VDD and the second power supply VSS.

In an embodiment, the emission unit EMU may include light-emitting elements LD connected in parallel between the pixel circuit PXC and the second power line PL2, as in the embodiment of FIG. 11. First ends EP1 of the light-emitting elements LD may be electrically connected to the pixel circuit PXC through the first pixel electrode ELT1 and may be electrically connected to the first power line PL1 through the pixel circuit PXC. Second ends EP2 of the light-emitting elements LD may be electrically connected to the second power line PL2 through a second pixel electrode ELT2. A voltage of the second power supply VSS may be applied to the second power line PL2.

The type, number, and/or structure of the light-emitting elements LD constituting the emission unit EMU of the pixel PXL may vary depending on embodiments. In addition, the arrangement and/or connection structure of the light-emitting elements LD may vary depending on embodiments.

In an embodiment, the emission unit EMU may include light-emitting elements LD connected in series and parallel between the pixel circuit PXC and the second power line PL2, as in the embodiment of FIG. 12. For example, the light-emitting elements LD may be arranged and/or connected to at least two series terminals between the pixel circuit PXC and the second power line PL2, and each series terminal may include at least one light-emitting element LD forward-connected between the first power supply VDD and the second power supply VSS. For example, the emission unit EMU may include at least one light-emitting element LD connected between a first pixel electrode ELT1 and a third pixel electrode ELT3 (e.g., at least one light-emitting element LD forward-connected to a first series terminal) and at least one light-emitting element LD connected between the third pixel electrode ELT3 and a second pixel electrode ELT2 (e.g., at least one light-emitting element LD forward-connected to a second series terminal). The third pixel electrode ELT3 may be an intermediate electrode connecting the first series terminal and the second series terminal.

The first power supply VDD and the second power supply VSS may have different potentials. For example, the first power supply VDD may be a high-potential pixel power supply, and the second power supply VSS may be a low-potential pixel power supply.

The light-emitting elements LD may emit light with a luminance corresponding to a driving current supplied through the pixel circuit PXC. During each frame period of the display period, the pixel circuit PXC may supply a driving current corresponding to a data signal to the emission unit EMU. The light-emitting elements LD may emit light with a luminance corresponding to the driving current.

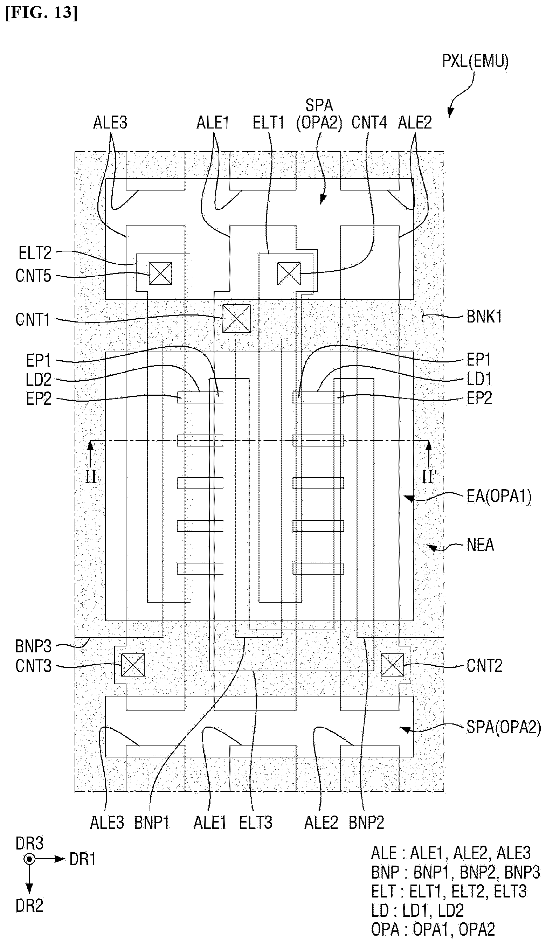

FIG. 13 is a plan view of a pixel PXL according to an embodiment. For example, FIG. 13 illustrates the structure of the pixel PXL centering on an emission unit EMU and shows an embodiment of the emission unit EMU including light-emitting elements LD which are connected in series and parallel to each other as in the embodiment of FIG. 12.

Referring to FIG. 13 in addition to FIGS. 1 through 12, the pixel PXL may include an emission area EA in which at least one light-emitting element LD is located. In an embodiment, the emission area EA may include at least two light-emitting elements LD and electrodes electrically connected to the light-emitting elements LD. In an embodiment, the electrodes may include alignment electrodes ALE and pixel electrodes ELT (also referred to as "contact electrodes"). In addition, the pixel PXL may further include bank patterns BNP located under the alignment electrodes ALE.

The alignment electrodes ALE may have various shapes and may be spaced apart from each other. In an embodiment, the alignment electrodes ALE may be spaced apart from each other along the first direction DR1 and may each have a shape (e.g., a bar shape) extending along the second direction DR2.

The shape, size, number, position, and/or arrangement structure of the alignment electrodes ALE may vary depending on embodiments. In addition, the alignment electrodes ALE may have similar or identical shapes and/or sizes or may have different shapes and sizes.

The alignment electrodes ALE may include at least two electrodes spaced apart from each other. For example, the alignment electrodes ALE may include a first alignment electrode ALE1, a second alignment electrode ALE2, and a third alignment electrode ALE3.

In an embodiment, the first alignment electrode ALE1 may be located in a center of the emission area EA, and the second alignment electrode ALE2 and the third alignment electrode ALE3 may be located on both sides of the first alignment electrode ALE1. For example, the second alignment electrode ALE2 may be located on a right side of the first alignment electrode ALE1, and the third alignment electrode ALE3 may be located on a left side of the first alignment electrode ALE1.

The alignment electrodes ALE (or alignment wirings before being separated into the alignment electrodes ALE of each pixel PXL) may be supplied with alignment signals necessary for the alignment of the light-emitting elements LD in an operation of aligning the light-emitting elements LD. Accordingly, the light-emitting elements LD may be aligned and/or arranged between the alignment electrodes ALE. When the light-emitting elements LD are aligned and/or arranged between the alignment electrodes ALE, it may mean that at least a portion of each of the light-emitting elements LD is located between the alignment electrodes ALE.

For example, the first alignment electrode ALE1, the second alignment electrode ALE2, and the third alignment electrode ALE3 (or a first alignment wiring to which the first alignment electrodes ALE1 of the pixels PXL are connected, a second alignment wiring to which the second alignment electrodes ALE2 of the pixels PXL are connected, and a third alignment wiring to which the third alignment electrodes ALE3 of the pixels PXL are connected) may be supplied with a first alignment signal, a second alignment signal, and a third alignment signal, respectively, in the operation of aligning the light-emitting elements LD. The first alignment signal and the second alignment signal may have different waveforms, potentials and/or phases, and the first alignment signal and the third alignment signal may have different waveforms, potentials and/or phases. The third alignment signal may be the same as or different from the second alignment signal. Accordingly, the light-emitting elements LD may be aligned between the first alignment electrode ALE1 and the second alignment electrode ALE2 and between the first alignment electrode ALE1 and the third alignment electrode ALE3.

The alignment electrodes ALE may be arranged in the emission area EA of each pixel PXL. In an embodiment, the alignment electrodes ALE may extend past a non-emission area NEA around the emission area EA to a separation area SPA. The separation area SPA may be an area where each alignment wiring (e.g., the first alignment wiring, the second alignment wiring, or the third alignment wiring) is separated into the alignment electrodes ALE of the pixels PXL (e.g., the first alignment electrodes ALE1, the second alignment electrodes ALE2, or the third alignment electrodes ALE3 of the pixels PXL) after the alignment of light-emitting elements LD is completed. The separation area SPA may be located on at least one side of each emission area EA.

For example, each pixel PXL may include at least one separation area SPA located around the emission area EA (e.g., two separation areas SPA located above and below each emission area EA). An end of at least one electrode constituting the emission unit EMU (e.g., ends of the alignment electrodes ALE) may be located in each separation area SPA.

In an embodiment, each alignment electrode ALE may be a separate pattern for each pixel PXL. For example, the first, second and third alignment electrodes ALE1, ALE2 and ALE3 of each pixel PXL may each be an individually separate pattern. However, embodiments are not limited to this example. For example, the alignment electrodes ALE connected to a second power line PL2 (e.g., the third alignment electrodes ALE3 of the pixels PXL) may be formed integrally with each other.

In an embodiment, the first alignment electrode ALE1 may be electrically connected to a pixel circuit PXC (e.g., a pixel circuit PXC of a corresponding pixel PXL) and/or a first power line PL1 located in a circuit layer (e.g., a circuit layer PCL of FIG. 14) through a first contact portion CNT1. In this case, the first alignment signal may be supplied to the first alignment electrode ALE1 (or the first alignment wiring) through at least one wiring (e.g., the first power line PL1) located in the circuit layer.

The first contact portion CNT1 may include at least one contact hole and/or via hole. In an embodiment, the first contact portion CNT1 may be located in the non-emission area NEA located around each emission area EA, but the position of the first contact portion CNT1 can be changed.

In an embodiment, the second alignment electrode ALE2 may be electrically connected to the second power line PL2 located in the circuit layer through a second contact portion CNT2. In this case, the second alignment signal may be supplied to the second alignment electrode ALE2 (or the second alignment wiring) through the second power line PL2.

The third alignment electrode ALE3 may be electrically connected to the second power line PL2 located in the circuit layer through a third contact portion CNT3. In this case, the second alignment signal may also be supplied to the third alignment electrode ALE3 (or the third alignment wiring) through the second power line PL2.

Each of the second contact portion CNT2 and the third contact portion CNT3 may include at least one contact hole and/or via hole. In an embodiment, the second contact portion CNT2 and the third contact portion CNT3 may be located in the non-emission area NEA, but the positions of the second contact portion CNT2 and the third contact portion CNT3 can be changed.

At least one first light-emitting element LD1 may be located between the first alignment electrode ALE1 and the second alignment electrode ALE2. For example, a plurality of first light-emitting elements LD1 may be arranged between the first alignment electrode ALE1 and the second alignment electrode ALE2.

Each first light-emitting element LD1 may or may not overlap the first alignment electrode ALE1 and/or the second alignment electrode ALE2. First ends EP1 of the first light-emitting elements LD1 may be adjacent to the first alignment electrode ALE1, and second ends EP2 of the first light-emitting elements LD1 may be adjacent to the second alignment electrode ALE2.

The first ends EP1 of the first light-emitting elements LD1 may be electrically connected to a first pixel electrode ELT1 (also referred to as a "first electrode"). In an embodiment, the first ends EP1 of the first light-emitting elements LD1 may be electrically connected to the first alignment electrode ALE1 through the first pixel electrode ELT1 and may be electrically connected to the pixel circuit PXC and/or the first power line PL1 through the first alignment electrode ALE1. In another embodiment, the first ends EP1 of the first light-emitting elements LD1 and the first pixel electrode ELT1 may be electrically connected to the pixel circuit PXC and/or the first power line PL1 without passing through the first alignment electrode ALE1.

The second ends EP2 of the first light-emitting elements LD1 may be electrically connected to a third pixel electrode ELT3 (also referred to as a "third electrode") and/or a second pixel electrode ELT2 (also referred to as a "second electrode"). In an embodiment, the second ends EP2 of the first light-emitting elements LD1 may be electrically connected to the third pixel electrode ELT3. In addition, the second ends EP2 of the first light-emitting elements LD1 may be electrically connected to the second power line PL2 sequentially via the third pixel electrode ELT3, at least one second light-emitting element LD2, the second pixel electrode ELT2, and the third alignment electrode ALE3.

At least one second light-emitting element LD2 may be located between the first alignment electrode ALE1 and the third alignment electrode ALE3. For example, a plurality of second light-emitting elements LD2 may be arranged between the first alignment electrode ALE1 and the third alignment electrode ALE3.

Each second light-emitting element LD2 may or may not overlap the first alignment electrode ALE1 and/or the third alignment electrode ALE3. First ends EP1 of the second light-emitting elements LD2 may be adjacent to the first alignment electrode ALE1, and second ends EP2 of the second light-emitting elements LD2 may be adjacent to the third alignment electrode ALE3.

The first ends EP1 of the second light-emitting elements LD2 may be electrically connected to the third pixel electrode ELT3. The second ends EP2 of the second light-emitting elements LD2 may be electrically connected to the second pixel electrode ELT2. In an embodiment, the second ends EP2 of the second light-emitting elements LD2 may be electrically connected to the third alignment electrode ALE3 through the second pixel electrode ELT2 and may be electrically connected to the second power line PL2 through the third alignment electrode ALE3. In another embodiment, the second ends EP2 of the second light-emitting elements LD2 and the second pixel electrode ELT2 may be electrically connected to the second power line PL2 without passing through the third alignment electrode ALE3.

For example, each light-emitting element LD (e.g., each first light-emitting element LD1 or each second light-emitting element LD2) may include the first end EP1 electrically connected to the first pixel electrode ELT1 and the second end EP2 electrically connected to the second pixel electrode ELT2. In an embodiment, each light-emitting element LD may be an ultra-small inorganic light-emitting element (e.g., having a small size in the range of nanometers to micrometers) using a material having an inorganic crystal structure. For example, each light-emitting element LD may be a light-emitting element LD according to at least one of the embodiments described with reference to FIGS. 1 through 9.

The light-emitting elements LD may be supplied to each emission area EA by an inkjet method or a slit coating method. The light-emitting elements LD may be aligned between the alignment electrodes ALE by alignment signals applied to the alignment electrodes ALE (or alignment wirings) and then may be fixed at the aligned position.

The first pixel electrode ELT1 may be located on the first ends EP1 of the first light-emitting elements LD1 and may be electrically connected to the first ends EP1 of the first light-emitting elements LD1. For example, the first pixel electrode ELT1 may be placed directly on the first ends EP1 of the first light-emitting elements LD1 to contact the first ends EP1 of the first light-emitting elements LD1.

In an embodiment, the first pixel electrode ELT1 may overlap the first alignment electrode ALE1 and may be electrically connected to the first alignment electrode ALE1 through a fourth contact portion CNT4. In addition, the first pixel electrode ELT1 may be electrically connected to the pixel circuit PXC and/or the first power line PL1 through the first alignment electrode ALE1. In another embodiment, the first pixel electrode ELT1 may be electrically connected to the pixel circuit PXC and/or the first power line PL1 without passing through the first alignment electrode ALE1.

The third pixel electrode ELT3 may be located on the second ends EP2 of the first light-emitting elements LD1 and the first ends EP1 of the second light-emitting elements LD2 and may be electrically connected to the second ends EP2 of the first light-emitting elements LD1 and the first ends EP1 of the second light-emitting elements LD2. For example, the third pixel electrode ELT3 may be placed directly on the second ends EP2 of the first light-emitting elements LD1 and the first ends EP1 of the second light-emitting elements LD2 to contact the second ends EP2 of the first light-emitting elements LD1 and the first ends EP1 of the second light-emitting elements LD2. The third pixel electrode ELT3 may electrically connect the first light-emitting elements LD1 and the second light-emitting elements LD2. In an embodiment, the third pixel electrode ELT3 may overlap a portion of each of the first and second alignment electrodes ALE1 and ALE2.

The second pixel electrode ELT2 (also referred to as the "second electrode") may be located on the second ends EP2 of the second light-emitting elements LD2 and may be electrically connected to the second ends EP2 of the second light-emitting elements LD2. For example, the second pixel electrode ELT2 may be placed directly on the second ends EP2 of the second light-emitting elements LD2 to contact the second ends EP2 of the second light-emitting elements LD2.

In an embodiment, the second pixel electrode ELT2 may overlap the third alignment electrode ALE3 and may be electrically connected to the third alignment electrode ALE3 through a fifth contact portion CNT5. In addition, the second pixel electrode ELT2 may be electrically connected to the second power line PL2 through the third alignment electrode ALE3. In another embodiment, the second pixel electrode ELT2 may be electrically connected to the second power line PL2 without passing through the third alignment electrode ALE3.

The pixel electrodes ELT may be formed separately from each other in each emission area EA. In an embodiment, at least one pixel electrode ELT may extend from each emission area EA to the non-emission area NEA and/or a separation area SPA. For example, the first pixel electrode ELT1 and the second pixel electrode ELT2 may extend from each emission area EA to the non-emission area NEA and a separation area SPA and may be electrically connected to the first alignment electrode ALE1 and the third alignment electrode ALE3 in the separation area SPA, respectively. The third pixel electrode ELT3 may be formed only in each emission area EA, or a portion of the third pixel electrode ELT3 may be located in the non-emission area NEA. The position, size, shape and arrangement structure of the pixel electrodes ELT and/or the positions of the fourth and fifth contact portions CNT4 and CNT5 may vary depending on embodiments.

The bank patterns BNP (also referred to as "patterns" or "wall patterns") may be located under the alignment electrodes ALE to partially overlap the alignment electrodes ALE. For example, the bank patterns BNP may include a first bank pattern BNP1, a second bank pattern BNP2, and a third bank pattern BNP3 which partially overlap the first alignment electrode ALE1, the second alignment electrode ALE2, and the third alignment electrode ALE3, respectively.

A portion of each of the alignment electrodes ALE may protrude in an upward direction (e.g., the third direction DR3) of a pixel PXL due to the bank patterns BNP. Accordingly, an area where the light-emitting elements LD are aligned can be easily controlled. In addition, since light emitted at a low angle toward the bank patterns BNP among the light emitted from the light-emitting elements LD is reflected in the upward direction of the pixel PXL, the light efficiency of the pixel PXL can be increased.

In an embodiment, at least two adjacent pixels PXL may share at least one bank pattern BNP. For example, the second bank pattern BNP2 may be integrally formed with the third bank pattern BNP3 of a neighboring pixel PXL (e.g., a neighboring pixel on the right) in the first direction DR1. The third bank pattern BNP2 may be integrally formed with the second bank pattern BNP2 of another neighboring pixel (e.g., a neighboring pixel on the left) in the first direction DR1. The position, structure, number, size, and/or shape of the bank patterns BNP may vary depending on embodiments.

The non-emission area NEA may be located around each emission area EA and/or each separation area SPA. A first bank BNK1 may be located in the non-emission area NEA.

The first bank BNK1 may include a first opening OPA1 corresponding to each emission area EA and may surround the emission area EA. In an embodiment, the first bank BNK1 may further include second openings OPA2 corresponding to the separation areas SPA and may surround the separation areas SPA. For example, the first bank BNK1 may include openings OPA corresponding to each emission area EA and each separation area SPA. The first bank BNK1 may define each emission area EA to which the light-emitting elements LD should be supplied in an operation of supplying the light-emitting elements LD to each pixel PXL.

In an embodiment, the first bank BNK1 may include a hydrophobic surface. For example, the first bank BNK1 itself may be formed as a hydrophobic pattern using a hydrophobic material, or a hydrophobic film containing a hydrophobic material may be formed on the first bank BNK1. For example, the first bank BNK1 may be formed using a hydrophobic organic insulating material having a large contact angle, such as polyacrylate. Accordingly, the light-emitting elements LD can be smoothly supplied to the emission areas EA.

FIG. 14 is a cross-sectional view of a display device DD according to an embodiment. For example, FIG. 14 is a cross-sectional view of a part of the display device DD, showing a cross-section of a pixel PXL corresponding to line II-II' of FIG. 13.

Referring to FIG. 14 in addition to FIGS. 1 through 13, the display device DD may include a base layer BSL, a circuit layer PCL, and a display layer DPL. The circuit layer PCL and the display layer DPL may be provided on the base layer BSL to overlap each other. For example, the circuit layer PCL and the display layer DPL may be sequentially arranged on a surface of the base layer BSL.

The display device DD may further include a color filter layer CFL and/or an encapsulation layer ENC (or a protective layer) located on the display layer DPL. In an embodiment, the color filter layer CFL and/or the encapsulation layer ENC may be formed directly on the surface of the base layer BSL on which the circuit layer PCL and the display layer DPL are formed, but embodiments are not limited to this case.

The base layer BSL may be a substrate or film containing a rigid or flexible material. In an embodiment, the base layer BSL may be an insulating substrate and may have a single-layer or multilayer structure.

The circuit layer PCL may be provided on the surface of the base layer BSL. The circuit layer PCL may include circuit elements constituting a pixel circuit PXC of each pixel PXL. For example, a plurality of circuit elements (e.g., transistors M and a capacitor Cst constituting each pixel circuit PXC) may be formed in each pixel area of the circuit layer PCL.

In FIG. 14, any one transistor M (e.g., a first transistor M1 including a bottom metal layer BML) provided in each pixel circuit PXC is illustrated as an example of the circuit elements that can be placed in the circuit layer PCL.

The circuit layer PCL may further include signal lines and power lines connected to the pixels PXL. For example, the circuit layer PCL may include scan lines SL, control lines SSL, data lines DL, sensing lines SENL, and/or first and second power lines PL1 and PL2 connected to the pixels PXL. In FIG. 14, wirings LI located in the same layer (e.g., a first conductive layer) as the bottom metal layer BML are illustrated as an example of wirings that can be placed in the circuit layer PCL. Each wiring LI may be one of the signal lines and the power lines connected to the pixels PXL. In an embodiment, at least one signal line and/or power line may also be located in another layer of the circuit layer PCL.

The circuit layer PCL may further include insulating layers. For example, the circuit layer PCL may include a buffer layer BFL, a gate insulating layer GI, an interlayer insulating layer ILD, and/or a passivation layer PSV sequentially arranged on the surface of the base layer BSL.

The circuit layer PCL may include a first conductive layer located on the base layer BSL and including the bottom metal layer BML of the first transistor M1. For example, the first conductive layer may be located between the base layer BSL and the buffer layer BFL and may include the bottom metal layer BML of the first transistor M1 provided in each pixel circuit PXC. The bottom metal layer BML of the first transistor M1 may overlap a semiconductor pattern SCP of the first transistor M1.

The first conductive layer may further include at least one wiring LI (or a portion of at least one wiring LI). For example, the first conductive layer may include at least some of the wirings LI extending in the second direction DR2 in a display area DA.

The buffer layer BFL may be located on the surface of the base layer BSL including the first conductive layer. The buffer layer BFL may prevent impurities from diffusing into each circuit element.

A semiconductor layer may be located on the buffer layer BFL. The semiconductor layer may include the semiconductor pattern SCP of each transistor M. The semiconductor pattern SCP may include a channel region overlapping a gate electrode GE of a corresponding transistor M and first and second conductive regions (e.g., source and drain regions) located on both sides of the channel region. The semiconductor pattern SCP may be a semiconductor pattern containing polysilicon, amorphous silicon, or an oxide semiconductor.

The gate insulating layer GI may be located on the semiconductor layer. A second conductive layer may be located on the gate insulating layer GI.

The second conductive layer may include the gate electrode GE of each transistor M. In addition, the second conductive layer may further include one electrode of the capacitor Cst provided in the pixel circuit PXC and/or a bridge pattern. Additionally, when at least one power line and/or signal line located in the display area DA is configured as a multilayer, the second conductive layer may further include at least one wiring (or a portion of the at least one wiring).

The interlayer insulating layer ILD may be located on the second conductive layer. A third conductive layer may be located on the interlayer insulating layer ILD.

The third conductive layer may include a source electrode SE and a drain electrode DE of each transistor M. The source electrode SE may be connected to a region (e.g., the source region) of the semiconductor pattern SCP included in a corresponding transistor M through at least one contact hole CH, and the drain electrode DE may be connected to another region (e.g., the drain region) of the semiconductor pattern SCP included in the corresponding transistor M through at least one other contact hole CH. In another embodiment, the source electrode SE and/or the drain electrode DE of at least one transistor M may not be located in the third conductive layer, but may be implemented as the source region and/or the drain region of the semiconductor pattern SCP.

In an embodiment, the third conductive layer may further include another electrode of the capacitor Cst provided in the pixel circuit PXC, at least one wiring, and/or a bridge pattern. For example, the third conductive layer may include at least some of wirings extending in the first direction DR1 in the display area DA.

Each of the electrodes, conductive patterns (e.g., bridge patterns), and/or wirings constituting the first through third conductive layers may have conductivity by containing a conductive material, and its material is not particularly limited. For example, each of the electrodes, conductive patterns, and/or wirings constituting the first through third conductive layers may contain one or more metals selected from molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W) and copper (Cu) or may include other conductive materials.

The passivation layer PSV may be located on the third conductive layer. Each of the buffer layer BFL, the gate insulating layer GI, the interlayer insulating layer ILD, and the passivation layer PSV may be a single layer or a multilayer and may contain an inorganic insulating material and/or an organic insulating material. In an embodiment, each of the buffer layer BFL, the gate insulating layer GI, and the interlayer insulating layer ILD may contain silicon nitride, silicon oxide, silicon oxynitride, or other inorganic insulating materials. In an embodiment, the passivation layer PSV may include at least one organic insulating layer containing an organic insulating material. In an embodiment, the passivation layer PSV may planarize a surface of the circuit layer PCL.

The display layer DPL may be located on the passivation layer PSV.

The display layer DPL may include an emission unit EMU of each pixel PXL. For example, the display layer DPL may include alignment electrodes ALE, at least one light-emitting element LD, and pixel electrodes ELT located in an emission area EA of each pixel PXL. In an embodiment, each emission unit EMU may include a plurality of light-emitting elements LD.

The display layer DPL may further include insulating patterns and/or insulating layers sequentially arranged on the surface of the base layer BSL on which the circuit layer PCL is formed. For example, the display layer DPL may include bank patterns BNP, a first insulating layer INS1, a first bank BNK1, a second insulating layer INS2, a third insulating layer INS3, a second bank BNK2, a fourth insulating layer INS4, a fifth insulating layer INS5, and/or a sixth insulating layer INS6. The display layer DPL may optionally further include a light conversion layer CCL.

The bank patterns BNP may be located on the passivation layer PSV. The bank patterns BNP may be located under the alignment electrodes ALE to overlap a portion of each of the alignment electrodes ALE.

Due to the bank patterns BNP, the alignment electrodes ALE may protrude around the light-emitting elements LD in the upward direction (e.g., the third direction DR3) of a pixel PXL. The bank patterns BNP and the alignment electrodes ALE on the bank patterns BNP may form reflective protruding patterns around the light-emitting elements LD. Accordingly, the light efficiency of the pixel PXL can be improved.

The bank patterns BNP may be single-layer or multilayer insulating patterns containing an inorganic insulating material and/or an organic insulating material. The alignment electrodes ALE may be located on the bank patterns BNP.

The alignment electrodes ALE may contain a conductive material. For example, each alignment electrode ALE may contain at least one conductive material selected from at least one of various metal materials such as silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo) and copper (Cu), an alloy thereof, a conductive oxide such as indium tin oxide (ITO), indium zinc oxide (IZO), indium tin zinc oxide (ITZO), zinc oxide (ZnO), aluminium doped zinc oxide (AZO), gallium doped zinc oxide (GZO), zinc tin oxide (ZTO), gallium tin oxide (GTO) or fluorine doped tin oxide (FTO) and a conductive polymer such as PEDOT, or other conductive materials. The alignment electrodes ALE may contain the same or different conductive materials.

Each alignment electrode ALE may be a single layer or a multilayer. In an embodiment, each alignment electrode ALE may include a reflective electrode layer containing a reflective conductive material (e.g., a metal).

The first insulating layer INS1 may be located on the alignment electrodes ALE. In an embodiment, the first insulating layer INS1 may include a contact hole for connecting at least one of the alignment electrodes ALE to any one pixel electrode ELT. For example, the first insulating layer INS1 may include contact holes for forming the fourth and fifth contact portions CNT4 and CNT5 of FIG. 13. In another embodiment, the first insulating layer INS1 may be opened more widely in the emission area EA to expose at least one of the alignment electrodes ALE, and each pixel electrode ELT may be directly located on each exposed alignment electrode ALE.

The first insulating layer INS1 may be a single layer or a multilayer. The first insulating layer INS1 may contain silicon nitride, silicon oxide, silicon oxynitride, or other insulating materials.

The first bank BNK1 may be located in the display area DA where the alignment electrodes ALE and the first insulating layer INS1 are formed. The first bank BNK1 may be located in a non-emission area NEA to surround the emission area EA of each pixel PXL.

Light-emitting elements LD may be placed in each emission area EA surrounded by the first bank BNK1. The light-emitting elements LD may be aligned between the alignment electrodes ALE. For example, at least one first light-emitting element LD1 may be aligned or arranged between a first alignment electrode ALE1 and a second alignment electrode ALE2, and at least one second light-emitting element LD2 may be aligned or arranged between the first alignment electrode ALE1 and a third alignment electrode ALE3.

The second insulating layer INS2 may be located on a portion of each of the light-emitting elements LD. In an embodiment, the second insulating layer INS2 may be locally located on a portion including a central portion of each of the light-emitting elements LD so as to expose first and second ends EP1 and EP2 of each of the light-emitting elements LD. In another embodiment, the second insulating layer INS2 may be formed over the entire display area DA including a plurality of pixel areas and may include contact holes exposing the first and second ends EP1 and EP2 of the light-emitting elements LD. The light-emitting elements LD may be stably fixed by the second insulating layer INS2.

The second insulating layer INS2 may be a single layer or a multilayer. The second insulating layer INS2 may contain silicon nitride, silicon oxide, silicon oxynitride, aluminium oxide, a photoresist material, or other insulating materials.

Different pixel electrodes ELT may be placed and/or formed on the first and second ends EP1 and EP2 of the light-emitting elements LD. For example, a first pixel electrode ELT1 may be placed on the first end EP1 of a first light-emitting element LD1, and a portion of a third pixel electrode ELT3 may be placed on the second end EP2 of the first light-emitting element LD1. Another portion of the third pixel electrode ELT3 may be placed on the first end EP1 of a second light-emitting element LD2, and a second pixel electrode ELT2 may be placed on the second end EP2 of the second light-emitting element LD2.

In an embodiment, the first pixel electrode ELT1 may be electrically connected to the first alignment electrode ALE1 through at least one contact portion (e.g., the fourth contact portion CNT4 of FIG. 13). The second pixel electrode ELT2 may be electrically connected to the third alignment electrode ALE3 through at least one contact portion (e.g., the fifth contact portion CNT5 of FIG. 13). The third pixel electrode ELT3 may electrically connect at least one first light-emitting element LD1 and at least one second light-emitting element LD2 to each other.

In an embodiment, the first alignment electrode ALE1 of each pixel PXL may be electrically connected to the first transistor M1 of the corresponding pixel PXL through at least one contact portion (e.g., the first contact portion CNT1 of FIG. 13). Similarly, each of the second and third alignment electrodes ALE2 and ALE3 may be electrically connected to the second power line PL2 through at least one contact portion (e.g., the second contact portion CNT2 or the third contact portion CNT3 of FIG. 13).

The first pixel electrode ELT1 may overlap a portion of the first alignment electrode ALE1, and the second pixel electrode ELT2 may overlap a portion of the third alignment electrode ALE3. The third pixel electrode ELT3 may overlap another portion of the first alignment electrode ALE1 and the second alignment electrode ALE2.

The first pixel electrode ELT1 may be electrically connected to the first end EP1 of the first light-emitting element LD1, and the second pixel electrode ELT2 may be electrically connected to the second end EP2 of the second light-emitting element LD2. The third pixel electrode ELT3 may be electrically connected to the second end EP2 of the first light-emitting element LD1 and the first end EP1 of the second light-emitting element LD2.

In an embodiment, the first pixel electrode ELT1, the second pixel electrode ELT2, and the third pixel electrode ELT3 may be located in the same layer as illustrated in FIG. 14. In another embodiment, some (e.g., the first pixel electrode ELT1 and the second pixel electrode ELT2) of the pixel electrodes ELT and the rest may be located in different layers. In this case, an insulating layer may be located between pixel electrodes ELT located in different layers.

In the case that each pixel PXL includes an emission unit EMU having a parallel structure as in the embodiment of FIG. 11 or when each pixel PXL includes a single light-emitting element LD, the pixel PXL may not include the third pixel electrode ELT3. In this case, the first pixel electrode ELT1 may be placed on the first ends EP1 of the light-emitting elements LD, and the second pixel electrode ELT2 may be placed on the second ends EP2 of the light-emitting elements LD.

The pixel electrodes ELT may contain at least one conductive material. In an embodiment, the pixel electrodes ELT may contain a transparent conductive material to transmit light emitted from the light-emitting elements LD.

The third insulating layer INS3 may be located on the pixel electrodes ELT. The third insulating layer INS3 may be a single layer or a multilayer. The third insulating layer INS3 may contain silicon nitride, silicon oxide, silicon oxynitride, or other insulating materials.

In an embodiment, the display device DD may include the light conversion layer CCL located on the emission unit EMU of each pixel PXL. For example, the light conversion layer CCL may be provided above the light-emitting elements LD of each pixel PXL in each emission area EA.

The display device DD may further include the second bank BNK2 located in the non-emission area NEA to overlap the first bank BNK1. The second bank BNK2 may define (or bound) each emission area EA where the light conversion layer CCL is to be formed. The second bank BNK2 may also be integrated with the first bank BNK1.

The second bank BNK2 may contain a light-blocking and/or reflective material, such as a black matrix material. The second bank BNK2 may contain the same or different material as the first bank BNK1.

The light conversion layer CCL may include at least one of wavelength conversion particles (or color conversion particles) for converting the color and/or wavelength of light emitted from the light-emitting elements LD and light-scattering particles SCT for scattering light emitted from the light-emitting elements LD to increase the light output efficiency of a pixel PXL. For example, each light conversion layer CCL may be located on each emission unit EMU. Each light conversion layer CCL may include wavelength conversion particles, such as at least one type of wavelength conversion particles WS (e.g., quantum dots corresponding to red, green, and/or blue) for converting incident light into light of a specific color, and/or light-scattering particles SCT. The wavelength conversion particles WS and/or the light-scattering particles SCT may be dispersed within a base resin BS of the light conversion layer CCL.

For example, when any one pixel PXL is set as a red (or green) pixel and blue light-emitting elements LD are provided in the emission unit EMU of the pixel PXL, a light conversion layer CCL including red (or green) wavelength conversion particles WS for converting blue light into red (or green) light may be placed on the emission unit EMU of the pixel PXL. In addition, the light conversion layer CCL may further include light-scattering particles SCT. In an embodiment, when any one pixel PXL is set as a blue pixel and blue light-emitting elements LD are provided in the emission unit EMU of the pixel PXL, a light conversion layer CCL including light-scattering particles SCT may be placed on the emission unit EMU of the pixel PXL.

At least one of the fourth insulating layer INS4, the fifth insulating layer INS5, and the sixth insulating layer INS6 may be formed on the surface of the base layer BSL including the emission units EMU and/or the light conversion layers CCL of the pixels PXL.

The fourth insulating layer INS4 may cover the emission units EMU and/or the light conversion layers CCL to protect the emission units EMU and/or the light conversion layers CCL of the pixels PXL. The fourth insulating layer INS4 may be a single layer or a multilayer. The fourth insulating layer INS4 may contain silicon nitride, silicon oxide, silicon oxynitride, or other insulating materials.

The fifth insulating layer INS5 may be located on the fourth insulating layer INS4. In an embodiment, the fifth insulating layer INS5 may be an overcoat layer including at least one organic insulating layer. The fifth insulating layer INS5 may substantially planarize a surface of the display layer DPL.

The sixth insulating layer INS6 may be located on the fifth insulating layer INS5. The sixth insulating layer INS6 may be a capping layer containing silicon nitride, silicon oxide, silicon oxynitride, or other insulating materials.

The color filter layer CFL may be located on the display layer DPL.

The color filter layer CFL may include color filters CF corresponding to the colors of the pixels PXL. For example, the color filter layer CFL may include a first color filter CF1 located in the emission area EA of a first color pixel PXL1, a second color filter CF2 located in the emission area EA of a second color pixel PXL2, and a third color filter CF3 located in the emission area EA of a third color pixel PXL3. Each color filter CF may be provided on the sixth insulating layer INS6 to overlap the emission unit EMU of a corresponding pixel PXL.

The first color filter CF1 may selectively transmit light of a first color. The second color filter CF2 may selectively transmit light of a second color. The third color filter CF3 may selectively transmit light of a third color.

In an embodiment, the first, second and third color filters CF1, CF2 CF3 may overlap each other in the non-emission area NEA and may function as light-blocking patterns. In another embodiment, the first, second and third color filters CF1, CF2 and CF3 may be formed separately from each other over the emission area EA of each pixel PXL, and a separate light-blocking pattern may be placed between the first, second and third color filters CF1, CF2 and CF3.

The encapsulation layer ENC may be located on the color filter layer CFL. The encapsulation layer ENC may include a seventh insulating layer INS7.

The seventh insulating layer INS7 may be a single layer or a multilayer.

In an embodiment, the seventh insulating layer INS7 may include at least one inorganic film to prevent the permeation of oxygen or moisture. In an embodiment, the seventh insulating layer INS7 may include at least one organic film to planarize the surface of the display device DD.

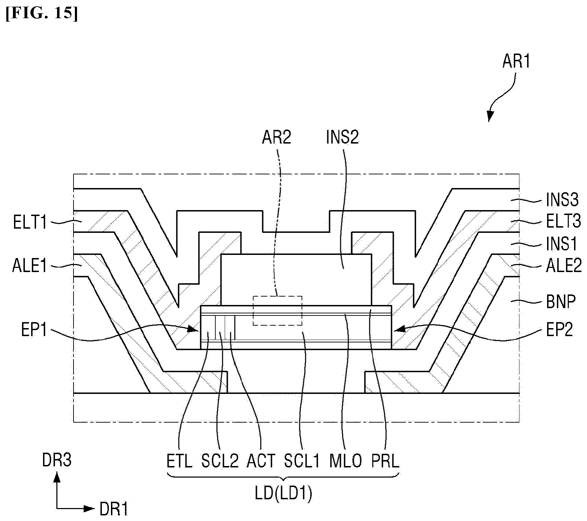

FIG. 15 is an enlarged view of an area of the pixel PXL illustrated in FIG. 14. For example, FIG. 15 is an enlarged cross-sectional view of an area (e.g., area AR1 of FIG. 14) of the pixel PXL centering on the first light-emitting element LD1. In an embodiment, the light-emitting elements LD included in the pixels PXL may be light-emitting elements LD of substantially the same or similar types and/or structures. For example, the second light-emitting element LD2 may be a light-emitting element LD of the same type and/or structure as the first light-emitting element LD1.

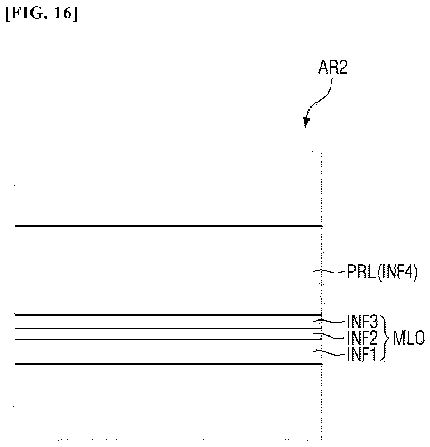

FIG. 16 is an enlarged view of an area of the light-emitting element LD illustrated in FIG. 15. For example, FIG. 16 shows an area (e.g., area AR2 of FIG. 15) of a light-emitting element LD according to an embodiment in which the pixel PXL of FIGS. 14 and 15 includes the light-emitting element LD of FIG. 3.

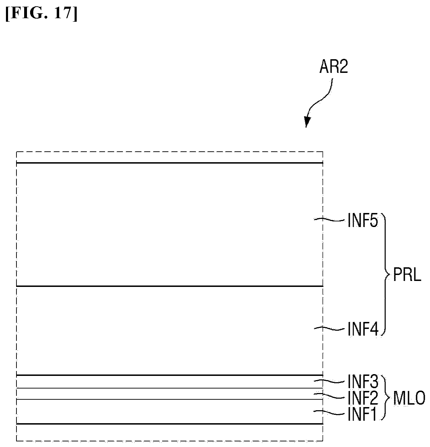

FIG. 17 is an enlarged view of an area of the light-emitting element LD illustrated in FIG. 15. For example, FIG. 17 shows an area (e.g., area AR2 of FIG. 15) of a light-emitting element LD according to an embodiment in which the pixel PXL of FIGS. 14 and 15 includes the light-emitting element LD of FIG. 4.

Referring to FIGS. 15 through 17 in addition to FIGS. 1 through 14, a pixel PXL of the display device DD may include at least two pixel electrodes ELT spaced apart from each other and at least one light-emitting element LD electrically connected between the pixel electrodes ELT. Each light-emitting element LD may include a first semiconductor layer SCL1, an active layer ACT and a second semiconductor layer SCL2 sequentially arranged along one direction and may optionally further include an electrode layer ETL. Each light-emitting element LD may further include a multilayer oxide insulating film MLO and a protective film PRL which surround outer peripheral surfaces of at least the first semiconductor layer SCL1, the active layer ACT and the second semiconductor layer SCL2.

The multilayer oxide insulating film MLO may include a first insulating film INF1 surrounding the outer peripheral surfaces of at least the first semiconductor layer SCL1, the active layer ACT and the second semiconductor layer SCL2, a second insulating film INF2 surrounding the first insulating film INF1, and a third insulating film INF3 surrounding the second insulating film INF2. The first insulating film INF1 may contain an M1ₓO_{y} type oxide (e.g., an M1O₂ type oxide). The second insulating film INF2 may contain an M2₂ₓO_{(2y-1)} type oxide (e.g., an M2₂O₃ type oxide). The third insulating film INF3 may contain an M3ₓO_{y} type oxide (e.g., an M3O₂ type oxide).

The protective film PRL may include at least one of a fourth insulating film INF4 and a fifth insulating film INF5 which surround the third insulating film INF3. For example, the protective film PRL may include only the fourth insulating film INF4 as illustrated in FIG. 16 or may include the fourth insulating film INF4 and the fifth insulating film INF5 as illustrated in FIG. 17. The protective film PRL may also be a multifilm of three or more layers, further including one or more insulating films.

As described above, a light-emitting element LD according to embodiments may include a first insulating film INF1 containing an M1ₓO_{y} type oxide, a second insulating film INF2 containing an M2₂ₓO_{(2y-1)} type oxide, and a third insulating film INF3 containing an M3ₓO_{y} type oxide. Oxygen vacancies Vo may be formed at interfaces of the first, second, and third insulating films INF1, INF2, and INF3.

According to embodiments, the introduction of oxygen into a light-emitting stack LES may be blocked or reduced by the oxygen vacancies V_{O} formed at the interfaces of the first, second, and third insulating films INF1, INF2, and INF3. Accordingly, the deterioration characteristics of the light-emitting element LD can be improved, and the reliability of the light-emitting element LD can be increased.

A display device DD according to embodiments may include a pixel PXL including the light-emitting element LD. Accordingly, the deterioration characteristics of the display device DD can be improved, and the reliability of the display device DD can be increased.

While the present disclosure has been particularly shown and described with reference to embodiments thereof, it will be understood by those of ordinary skill in the art that various changes in form and detail may be made therein without departing from the spirit and scope of the present disclosure as defined by the following claims. The embodiments should be considered in a descriptive sense only and not for purposes of limitation.

## Claims

1. A light-emitting element comprising:
a first semiconductor layer, an active layer, and a second semiconductor layer, which are sequentially arranged in one direction;
a first insulating film surrounding outer peripheral surfaces of the first semiconductor layer, the active layer and the second semiconductor layer and containing an M1ₓO_{y} type oxide;
a second insulating film surrounding the first insulating film and containing an M2₂ₓO_{(2y-1)} type oxide;
a third insulating film surrounding the second insulating film and containing an M3ₓO_{y} type oxide; and
a fourth insulating film surrounding the third insulating film,
wherein M1, M2 and M3 are each a metal material, and x and y are each a natural number.

2. The light-emitting element of claim 1, wherein the sum of thicknesses of the first insulating film, the second insulating film, and the third insulating film is 10 nm or less.

3. The light-emitting element of claim 2, wherein the fourth insulating film has a thickness greater than the sum of the thicknesses of the first insulating film, the second insulating film, and the third insulating film.

4. The light-emitting element of claim 1, wherein the thickness of the first insulating film is greater than the thickness of the second insulating film.

5. The light-emitting element of claim 4, wherein the thickness of the third insulating film is equal to or greater than the thickness of the second insulating film.

6. The light-emitting element of claim 1, wherein the first insulating film contains an M1O₂ type oxide, the second insulating film contains an M2₂O₃ type oxide, and the third insulating film contains an M3O₂ type oxide.

7. The light-emitting element of claim 6, wherein the first insulating film contains at least one of SiO₂, ZrO₂, HfO₂, GeO₂, TiO₂ and TeO₂, and the second insulating film contains at least one of Al₂O₃, Y₂O₃, La₂O₃, Ce₂O₃, Lu₂O₃, Sc₂O₃ and Yb₂O₃.

8. The light-emitting element of claim 7, wherein the third insulating film contains at least one of SiO₂, ZrO₂, HfO₂, GeO₂, TiO₂, and TeO₂.

9. The light-emitting element of claim 8, wherein the first insulating film contains ZrO₂, the second insulating film contains Al₂O₃, and the third insulating film contains ZrO₂.

10. The light-emitting element of claim 1, further comprising a fifth insulating film surrounding the fourth insulating film and having a thickness greater than the thickness of the fourth insulating film.

11. The light-emitting element of claim 10, wherein the fourth insulating film is an inorganic film containing an oxide, and the fifth insulating film is an inorganic film containing an oxide different from a material of the fourth insulating film.

12. A light-emitting element comprising:
a first semiconductor layer, an active layer, and a second semiconductor layer, which are sequentially arranged in one direction;
a first insulating film surrounding outer peripheral surfaces of the first semiconductor layer, the active layer and the second semiconductor layer and containing an M1ₓO_{y} type oxide;
a second insulating film surrounding the first insulating film and containing an M2₂ₓO_{(2y-1)} type oxide;
a third insulating film surrounding the second insulating film and containing an M3ₓO_{y} type oxide,
wherein M1, M2 and M3 are each a metal material, x and y are each a natural number, a thickness of the first insulating film is greater than a thickness of the second insulating film, and a thickness of the third insulating film is equal to or greater than the thickness of the second insulating film.

13. The light-emitting element of claim 12, wherein the sum of the thicknesses of the first insulating film, the second insulating film, and the third insulating film is 10 nm or less.

14. The light-emitting element of claim 12, wherein the first insulating film contains an M1O₂ type oxide, the second insulating film contains an M2₂O₃ type oxide, and the third insulating film contains an M3O₂ type oxide.

15. The light-emitting element of claim 14, wherein the first insulating film contains at least one of SiO₂, ZrO₂, HfO₂, GeO₂, TiO₂ and TeO₂, and the second insulating film contains at least one of Al₂O₃, Y₂O₃, La₂O₃, Ce₂O₃, Lu₂O₃, Sc₂O₃ and Yb₂O₃.

16. The light-emitting element of claim 15, wherein the third insulating film contains at least one of SiO₂, ZrO₂, HfO₂, GeO₂, TiO₂, and TeO₂.

17. The light-emitting element of claim 16, wherein the first insulating film contains ZrO₂, the second insulating film contains Al₂O₃, and the third insulating film contains ZrO₂.

18. The light-emitting element of claim 12, further comprising a fourth insulating film surrounding the third insulating film and having a thickness greater than the sum of the thicknesses of the first insulating film, the second insulating film and the third insulating film.

19. The light-emitting element of claim 18, further comprising a fifth insulating film surrounding the fourth insulating film and having a thickness greater than the thickness of the fourth insulating film.

20. A display device comprising a pixel which comprises a first electrode and a second electrode spaced apart from each other and a light-emitting element electrically connected between the first electrode and the second electrode, wherein the light-emitting element comprises:
a first semiconductor layer, an active layer, and a second semiconductor layer, which are sequentially arranged in one direction;
a first insulating film surrounding outer peripheral surfaces of the first semiconductor layer, the active layer and the second semiconductor layer and containing an M1ₓO_{y} type oxide;
a second insulating film surrounding the first insulating film and containing an M2₂ₓO_{(2y-1)} type oxide;
a third insulating film surrounding the second insulating film and containing an M3ₓO_{y} type oxide; and
a fourth insulating film surrounding the third insulating film,
wherein M1, M2 and M3 are each a metal material, and x and y are each a natural number.

21. The display device of claim 20, wherein the sum of thicknesses of the first insulating film, the second insulating film, and the third insulating film is 10 nm or less.

22. The display device of claim 21, wherein the fourth insulating film has a thickness greater than the sum of the thicknesses of the first insulating film, the second insulating film, and the third insulating film.

23. The display device of claim 20, wherein the thickness of the first insulating film is greater than the thickness of the second insulating film, and the thickness of the third insulating film is equal to or greater than the thickness of the second insulating film.

24. The display device of claim 20, wherein the first insulating film contains an M1O₂ type oxide, the second insulating film contains an M2₂O₃ type oxide, and the third insulating film contains an M3O₂ type oxide.

25. The display device of claim 24, wherein the first insulating film contains at least one of SiO₂, ZrO₂, HfO₂, GeO₂, TiO₂ and TeO₂, and the second insulating film contains at least one of Al₂O₃, Y₂O₃, La₂O₃, Ce₂O₃, Lu₂O₃, Sc₂O₃ and Yb₂O₃.

26. The display device of claim 25, wherein the third insulating film contains at least one of SiO₂, ZrO₂, HfO₂, GeO₂, TiO₂, and TeO₂.

27. The display device of claim 26, wherein the first insulating film contains ZrO₂, the second insulating film contains Al₂O₃, and the third insulating film contains ZrO₂.

28. The display device of claim 20, further comprising a fifth insulating film surrounding the fourth insulating film and having a thickness greater than the thickness of the fourth insulating film.

29. The display device of claim 28, wherein the fourth insulating film is an inorganic film containing an oxide, and the fifth insulating film is an inorganic film containing an oxide different from a material of the fourth insulating film.

30. The display device of claim 20, wherein the pixel further comprises a first alignment electrode and a second alignment electrode located under the light-emitting element and spaced apart from each other.
